(19) Europäisches Patentamt / European Patent Office / Office européen des brevets

(11) EP 4 159 431 A1

(12) EUROPEAN PATENT APPLICATION
published in accordance with Art. 153(4) EPC

(43) Date of publication:
05.04.2023 Bulletin 2023/14

(21) Application number: 21812566.4

(22) Date of filing: 25.05.2021

(51) International Patent Classification (IPC):
*B32B 17/10* (2006.01) *B32B 27/34* (2006.01)
*C08L 79/08* (2006.01) *G09F 9/00* (2006.01)
*H05B 33/02* (2006.01) *H05B 33/10* (2006.01)
*H01L 51/50* (2006.01)

(52) Cooperative Patent Classification (CPC):
**B32B 17/10; B32B 27/34; C08L 79/08; G09F 9/00; H05B 33/02; H05B 33/10; H10K 50/00;**
Y02E 10/549

(86) International application number:
PCT/JP2021/019786

(87) International publication number:
WO 2021/241570 (02.12.2021 Gazette 2021/48)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 29.05.2020 JP 2020094845
09.11.2020 JP 2020186386

(71) Applicant: TOYOBO CO., LTD.
Osaka-shi
Osaka 5300001 (JP)

(72) Inventors:
- OKUYAMA, Tetsuo
Otsu-shi, Shiga 520-0292 (JP)
- NAKAMURA, Makoto
Otsu-shi, Shiga 520-0292 (JP)
- MIZUGUCHI, Denichirou
Otsu-shi, Shiga 520-0292 (JP)
- YONEMUSHI, Harumi
Otsu-shi, Shiga 520-0292 (JP)
- WAKUI, Hiroyuki
Otsu-shi, Shiga 520-0292 (JP)
- TOKUDA, Kaya
Otsu-shi, Shiga 520-0292 (JP)

(74) Representative: Vossius & Partner
Patentanwälte Rechtsanwälte mbB
Siebertstraße 3
81675 München (DE)

# (54) MULTILAYER BODY COMPRISING HIGHLY HEAT-RESISTANT TRANSPARENT FILM

(57) The present invention provides a multilayer body of an inorganic substrate and a highly heat-resistant transparent film which has sufficient heat resistance and is able to be mechanically separated from the inorganic substrate after being subjected to various processes on the inorganic substrate since the adhesion between the highly heat-resistant transparent film and the inorganic substance is adequately weak. A multilayer body of a highly heat-resistant transparent film and an inorganic substrate, wherein: an adhesive is not substantially used; the peel strength between the highly heat-resistant transparent film and the inorganic substrate is 0.3 N/cm or less; and the CTE of the highly heat-resistant transparent film is 50 ppm/K or less.

EP 4 159 431 A1

Fig.2

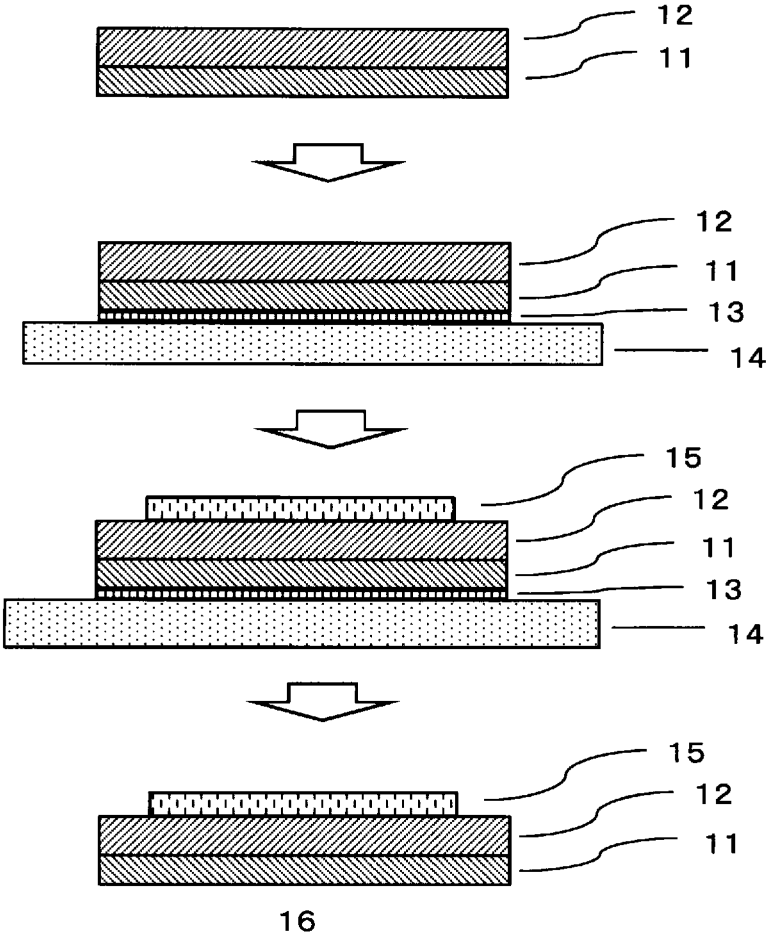

## Description

TECHNICAL FIELD

The present invention relates to a laminate including a highly heat-resistant transparent film.

BACKGROUND ART

In recent years, there has been an increasing demand for sheets which are equipped with a plurality of devices mounted at intervals and exhibit both flexibility and elasticity. Such sheets are supposed to be used by being fitted to, for example, a curved surface such as the body. Such sheets are also supposed to be used in electronic devices having a bent portion and electronic devices capable of being wound. When these sheets are transparent, the sheets are used in various promising ways including mainly display applications, and studies are being actively conducted to this end.

Patent Document 1 discloses a method for manufacturing a polyimide film for supporting base material, which can be made thin, lightweight, and flexible, has no problem of cracking and peeling off due to thermal stress, and is used in the manufacture of an organic EL device exhibiting excellent dimensional stability and the like. The method is a method for manufacturing a polyimide film for display device supporting base material, which includes applying a resin solution of polyimide or a polyimide precursor onto the base substrate so that the thickness of polyimide film is 50 um or less, completing a heat treatment to form a polyimide film on the base substrate, and separating the polyimide film from the base substrate, and in which the polyimide film has a transmittance of 80% or more in a wavelength region of 440 nm to 780 nm and a transmittance of 80% or less at 400 nm and the bottom surface of the polyimide film is irradiated with laser light through the base substrate in order to separate the polyimide film and the base substrate from each other.

In addition, Patent Document 2 states that it is extremely significant when a laminate, which exhibits excellent heat resistance and insulating properties and obtained by laminating a polyimide film that exhibits heat resistance and flexibility at higher levels and a kind of inorganic layer selected from a glass plate, a ceramic plate, a silicon wafer, or a metal, is used in the fabrication of electronic devices, optical functional parts, electronic parts, and the like as a laminate having a silane coupling layer between an inorganic layer and a polyimide film layer.

PRIOR ART DOCUMENTS

PATENT DOCUMENTS

Patent Document 1: JP-A-2018-132768
Patent Document 2: JP-B-5304490

DISCLOSURE OF THE INVENTION

PROBLEMS TO BE SOLVED BY THE INVENTION

However, in the method for manufacturing a circuit board as described in Patent Document 1, it is required to irradiate the entire bottom surface of the polyimide film with laser light through the base substrate, and the productivity is thus poor. In particular, when the area is large, it is required to perform laser processing at high precision, and this is not suitable for mass production. Since smears are generated during laser processing, these smears become particles and cause damage to the device or breaking of wire. In the laminate described in Patent Document 2, the 180-degree peel strength between the inorganic layer and the polyimide film is as strong as 1 N/cm or more, and it is difficult to form a device on the polyimide film layer and then mechanically peel off the device-formed polyimide film.

The present invention has been made in view of the above-mentioned problems, and an object thereof is to provide a method for manufacturing a device connected body, by which it is easy to manufacture a film with an electronic device and mass production is possible since it is remarkably easy to peel off a highly heat-resistant transparent film from an inorganic substrate after a device is formed on the highly heat-resistant transparent film. An object of the present invention is also to provide a laminate of a highly heat-resistant transparent film and an inorganic substrate for fabrication of the device.

The present inventors have diligently studied the manufacture of a device on a highly heat-resistant transparent film. As a result, the present inventors have found out that the manufacture of a device on a highly heat-resistant transparent film is easy and mass production is possible when the following configuration is adopted, and have thus completed the present invention. In other words, the laminate according to the present invention has the following

configuration.

A laminate including a highly heat-resistant transparent film and an inorganic substrate, in which

an adhesive is not substantially used,
a peel strength between the highly heat-resistant transparent film and the inorganic substrate is 0.3 N/cm or less, and
a CTE of the highly heat-resistant transparent film is 50 ppm/K or less.

It is preferable that the highly heat-resistant transparent film has a laminated configuration of two or more layers, and a thickness of intermingling at an interface between a first highly heat-resistant transparent film layer that is in contact with the inorganic substrate and a second highly heat-resistant transparent film layer that is not in contact with the inorganic substrate but is adjacent to the first highly heat-resistant transparent film layer is 800 nm or less.

It is preferable that the highly heat-resistant transparent film has a laminated configuration of two or more layers, and a CTE of a first highly heat-resistant transparent film layer that is in contact with the inorganic substrate singly is 20 ppm/K or less.

It is preferable that the highly heat-resistant transparent film has a laminated configuration of two or more layers, and a first highly heat-resistant transparent film layer that is in contact with the inorganic substrate is transparent polyimide.

It is preferable that the highly heat-resistant transparent film has a laminated configuration of two or more layers, and at least one layer of a second highly heat-resistant transparent film layer that is not in contact with the inorganic substrate is transparent polyimide.

It is preferable that the highly heat-resistant transparent film has a laminated configuration of two or more layers, and a first highly heat-resistant transparent film layer that is in contact with the inorganic substrate includes a structure represented by Formula 1 and/or a structure represented by Formula 2:

[Formula 1]

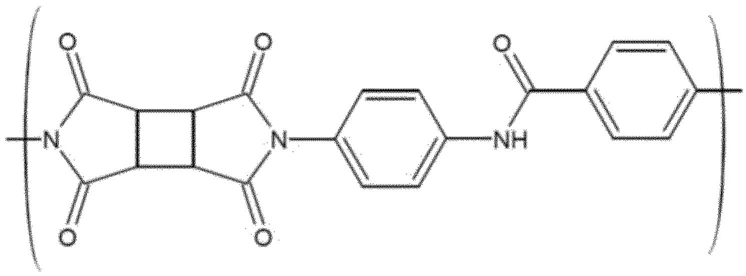

[Formula 2]

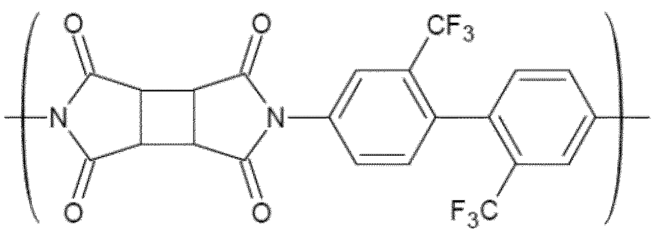

It is preferable that a long side of the inorganic substrate is 300 mm or more.

A method for manufacturing a film with an electronic device, the method including forming an electronic device on a highly heat-resistant transparent film of the laminate and then peeling off the electronic device-formed highly heat-resistant transparent film from an inorganic substrate.

## EFFECT OF THE INVENTION

According to the present invention, it is possible to provide a method for manufacturing a device connected body, by which it is easy to manufacture a film with an electronic device and mass production is possible since it is remarkably easy to peel off a device-formed highly heat-resistant transparent film from an inorganic substrate. It is also

possible to provide a laminate of the highly heat-resistant transparent film and an inorganic substrate.

BRIEF DESCRIPTION OF THE DRAWINGS

Fig. 1 is a schematic diagram for explaining a method for applying a silane coupling agent according to the present patent.
Fig. 2 is an example of a schematic cross-sectional diagram for explaining a method for manufacturing a film with an electronic device according to the present patent.
Fig. 3 is another example of a schematic cross-sectional diagram for explaining a method for manufacturing a film with an electronic device according to the present patent.
Fig. 4 is an example of a schematic cross-sectional diagram for explaining the measurement of warpage of a laminate of a highly heat-resistant transparent film and an inorganic substrate according to the present patent.

MODE FOR CARRYING OUT THE INVENTION

Hereinafter, embodiments of the present invention will be described.

<Highly heat-resistant transparent film>

In the present specification, the highly heat-resistant transparent film is a film having a melting point of preferably 250°C or more, more preferably 300°C or more, still more preferably 400°C or more. The highly heat-resistant transparent film is a film formed from a polymer having a glass transition temperature of preferably 200°C or more, more preferably 320°C or more, still more preferably 380°C or more. Hereinafter, the highly heat-resistant transparent film is also simply referred to as a polymer in order to avoid complication. In the present specification, the melting point and the glass transition temperature are determined by differential thermal analysis (DSC). In a case where the melting point exceeds 500°C, it may be determined whether or not the temperature has reached the melting point by visually observing the thermal deformation behavior when the highly heat-resistant transparent film is heated at this temperature.

As the transparency, it is preferable that the total light transmittance is 75% or more. The total light transmittance is more preferably 80% or more, still more preferably 85% or more, yet still more preferably 87% or more, particularly preferably 88% or more. The upper limit of the total light transmittance of the highly heat-resistant transparent film is not particularly limited, but is preferably 98% or less, more preferably 97% or less for use as a film with an electronic device (hereinafter, also referred to as a flexible electronic device).

Examples of the highly heat-resistant transparent film (hereinafter, also simply referred to as a polymer film) include films of polyimide-based resins (for example, aromatic polyimide resin and alicyclic polyimide resin) such as polyimide, polyamide-imide, polyetherimide, and fluorinated polyimide; copolymerized polyesters (for example, fully aromatic polyester and semi-aromatic polyester) such as polyethylene, polypropylene, polyethylene terephthalate, polybutylene terephthalate, and polyethylene-2,6-naphthalate; copolymerized (meth)acrylate typified by polymethyl methacrylate; polycarbonate; polyamide; polysulfone; polyether sulfone; polyether ketone; cellulose acetate; cellulose nitrate; aromatic polyamide; polyvinyl chloride; polyphenol; polyarylate; polyacetal; modified polyphenylene ether; polyphenylene sulfide; polyphenylene oxide; polystyrene; polybenzoxazole; polybenzothiazole; polybenzimidazole; cyclic polyolefin; liquid crystal polymer; and the like. Examples of the highly heat-resistant transparent film also include those obtained by reinforcing these with glass fillers, glass fibers and the like.

However, since the polymer film is premised on being used in a process involving heat treatment at 250°C or more, those that can actually be adopted among the exemplified polymer films are limited. Among the polymer films, a film obtained using a so-called super engineering plastic is preferable, and more specific examples thereof include an aromatic polyimide film, an alicyclic polyimide film, an aromatic amide film, an aromatic amide-imide film, an amide-imide film, an aromatic benzoxazole film, an aromatic benzothiazole film, an aromatic benzimidazole film, a cyclic polyolefin, and a liquid crystal polymer.

The details of the polyimide-based resin film (referred to as a polyimide film in some cases) which is an example of the polymer film will be described below. Generally, the polyimide-based resin film is obtained by applying a polyamic acid (polyimide precursor) solution which is obtained by a reaction between a diamine and a tetracarboxylic acid in a solvent, to a support for polyimide film fabrication, drying the solution to form a green film (hereinafter also referred to as "precursor film" or "polyamic acid film"), and further treating the green film by heat at a high temperature on the support for polyimide film fabrication or in a state of being peeled off from the support to cause a dehydration ring-closure reaction. Here, the green film is a film of polyamic acid that contains a solvent and exhibits self-supporting properties. The solvent content in the green film is not particularly limited as long as self-supporting properties are exhibited, but is preferably

1% by mass or more, more preferably 5% by mass or more, still more preferably 10% by mass or more, yet still more preferably 20% by mass or more, particularly preferably 30% by mass or more. The solvent content in the green film is preferably 80% by mass or less, more preferably 70% by mass or less, still more preferably 60% by mass or less, particularly preferably 50% by mass or less.

For the application of the polyamic acid (polyimide precursor) solution, it is possible to appropriately use, for example, conventionally known solution application means such as spin coating, doctor blade, applicator, comma coater, screen printing method, slit coating, reverse coating, dip coating, curtain coating, and slit die coating. Since the method for forming a film by applying a polyamic acid solution has a wide range of material choices, the method is easily considered in order to find a material preferable for easy peeling off, but on the other hand, it is required to control the imidization reaction in the method. In contrast, film formation that does not involve an imidization reaction has an advantage that film formation is easy, and it is thus required to use the methods properly.

The polyimide film in the present invention is a polymer film having an imide bond in the main chain, and is preferably a polyimide film and a polyamide-imide film, more preferably a polyimide film. A polyamide film is also preferable.

Generally, a polyimide film is obtained by applying a polyamic acid (polyimide precursor) solution obtained by a reaction between a diamine and a tetracarboxylic acid in a solvent to a support for polyimide film fabrication, drying the solution to form a green film, and further treating the green film by heat at a high temperature on the support for polyimide film fabrication or in a state of being peeled off from the support to cause a dehydration ring-closure reaction as described above. As another method, a polyimide film is also obtained by applying a polyimide solution obtained by a dehydration ring-closure reaction between a diamine and a tetracarboxylic acid in a solvent to a support for polyimide film fabrication, drying the solution to form a polyimide film containing a solvent at, for example, 1% to 50% by mass, and further treating the polyimide film containing a solvent at 1% to 50% by mass at a high temperature on the support for polyimide film fabrication or in a state of being peeled off from the support for drying.

Generally, a polyamide-imide film is obtained by applying a polyamide-imide solution obtained by a reaction between a diisocyanate and a tricarboxylic in a solvent to a support for polyamide-imide film fabrication, drying the solution to form a polyamide-imide film containing a solvent at, for example, 1% to 50% by mass, and further treating the polyamide-imide film containing a solvent at 1% to 50% by mass at a high temperature on the support for polyamide-imide film fabrication or in a state of being peeled off from the support for drying.

Generally, a polyamide film is obtained by applying a polyamide solution obtained by a reaction between a diamine and a dicarboxylic acid in a solvent to a support for polyamide film fabrication, drying the solution to form a polyamide film containing a solvent at, for example, 1% to 50% by mass, and further treating the polyamide film containing a solvent at 1% to 50% by mass at a high temperature on the support for polyamide film fabrication or in a state of being peeled off from the support for drying.

As the tetracarboxylic acids, tricarboxylic acids, and dicarboxylic acids, it is possible to use aromatic tetracarboxylic acids (including acid anhydrides thereof), aliphatic tetracarboxylic acids (including acid anhydrides thereof), alicyclic tetracarboxylic acids (including acid anhydrides thereof), aromatic tricarboxylic acids (including acid anhydrides thereof), aliphatic tricarboxylic acids (including acid anhydrides thereof), alicyclic tricarboxylic acids (including acid anhydrides thereof), aromatic dicarboxylic acids, aliphatic dicarboxylic acids, alicyclic dicarboxylic acids and the like that are usually used in the polyimide synthesis, polyamide-imide synthesis, and polyamide synthesis. Among these, aromatic tetracarboxylic anhydrides and alicyclic tetracarboxylic anhydrides are preferable, aromatic tetracarboxylic anhydrides are more preferable from the viewpoint of heat resistance, and alicyclic tetracarboxylic acids are more preferable from the viewpoint of light transmittance. In a case where tetracarboxylic acids are acid anhydrides, the acid anhydrides may have one anhydride structure or two anhydride structures in the molecule, but one (dianhydride) having two anhydride structures in the molecule is preferable. Tetracarboxylic acids, tricarboxylic acids, and dicarboxylic acids may be used singly or in combination of two or more kinds thereof.

Examples of the aromatic tetracarboxylic acids for obtaining a highly colorless and transparent polyimide in the present invention include tetracarboxylic acids such as 4,4'-(2,2-hexafluoroisopropyridene)diphthalic acid, 4,4'-oxydiphthalic acid, bis(1,3-dioxo-1,3-dihydro-2-benzofuran-5-carboxylic acid) 1,4-phenylene, bis(1,3-dioxo-1,3-dihydro-2-benzofuran-5-yl)benzene-1,4-dicarboxylate, 4,4'-[4,4'-(3-oxo-1,3-dihydro-2-benzofuran-1,1-diyl) bis(benzene-1,4-diyloxy)]dibenzene-1,2-dicarboxylic acid, 3,3',4,4'-benzophenonetetracarboxylic acid, 4,4'-[(3-oxo-1,3-dihydro-2-benzofuran-1,1-diyl) bis(toluene-2,5-diyloxy)]dibenzene-1,2-dicarboxylic acid, 4,4'-[(3-oxo-1,3-dihydro-2-benzofuran-1,1-diyl) bis(1,4-xylene-2,5-diyloxy)]dibenzene-1,2-dicarboxylic acid, 4,4'-[4,4'-(3-oxo-1,3-dihydro-2-benzofuran-1,1-diyl) bis(4-isopropyltoluene-2,5-diyloxy)]dibenzene-1,2-dicarboxylic acid, 4,4'-[4,4'-(3-oxo-1,3-dihydro-2-benzofuran-1,1-diyl) bis(naphthalene-1,4-diyloxy)]dibenzene-1,2-dicarboxylic acid, 4,4'-[4,4'-(3H-2,1-benzoxathiol-1,1-dioxide-3,3-diyl) bis(benzene-1,4-diyloxy)]dibenzene-1,2-dicarboxylic acid, 4,4'-benzophenone tetracarboxylic acid, 4,4'-[(3H-2,1-benzoxathiol-1,1-dioxide-3,3-diyl) bis(toluene-2,5-diyloxy)]dibenzene-1,2-dicarboxylic acid, 4,4'-[(3H-2,1-benzoxathiol-1,1-dioxide-3,3-diyl) bis(1,4-xylene-2,5-diyloxy)]dibenzene-1,2-dicarboxylic acid, 4,4'-[4,4'-(3H-2,1-benzoxathiol-1,1-dioxide-3,3-diyl) bis(4-isopropyltoluene-2,5-diyloxy)]dibenzene-1,2-dicarboxylic acid, 4,4'-[4,4'-(3H-2,1-benzoxathiol-1,1-dioxide-3,3-diyl) bis(naphthalene-1,4-diyloxy)]dibenzene-1,2-dicarboxylic acid, 3,3',4,4'-benzophenonetetracarboxylic acid, 3,3',4,4'-benzophenonetetracarboxylic acid, 3,3',4,4'-diphenylsulfonetetracarboxylic acid, 3,3',4,4'-biphenyltetracarboxylic acid, 2,3,3',4'-biphenyltetracarboxylic acid, 2,2',3,3'-biphenyltetracarboxylic acid, 2,2'-diphenoxy-4,4',5,5'-biphenyltetracarboxylic acid, pyromellitic acid, 4,4'-[spiro(xanthene-9,9'-fluorene)-2,6-diyl bis(oxycarbonyl)]diphthalic acid, and 4,4'-[spiro(xanthene-9,9'-fluorene)-3,6-diyl bis(oxycarbonyl)] diphthalic acid, and acid anhydrides thereof. Among these, dianhydrides having two acid anhydride structures are suitable, and particularly 4,4'-(2,2-hexafluoroisopropyridene)diphthalic dianhydride and 4,4'-oxydiphthalic dianhydride are preferable. The aromatic tetracarboxylic acids may be used singly or in combination of two or more kinds thereof. For obtaining high heat resistance, the amount of the aromatic tetracarboxylic acids copolymerized is, for example, preferably 50% by mass or more, more preferably 60% by mass or more, still more preferably 70% by mass or more, yet still more preferably 80% by mass or more of the total amount of all the tetracarboxylic acids.

Examples of the alicyclic tetracarboxylic acids include tetracarboxylic acids such as 1,2,3,4-cyclobutanetetracarboxylic acid, 1,2,3,4-cyclopentanetetracarboxylic acid, 1,2,3,4-cyclohexanetetracarboxylic acid, 1,2,4,5-cyclohexanetetracarboxylic acid, 3,3',4,4'-bicyclohexyltetracarboxylic acid, bicyclo[2,2,1]heptane-2,3,5,6-tetracarboxylic acid, bicyclo[2,2,2]octane-2,3,5,6-tetracarboxylic acid, bicyclo[2,2,2]octo-7-ene-2,3,5,6-tetracarboxylic acid, tetrahydroanthracene-2,3,6,7-tetracarboxylic acid, tetradecahydro-1,4:5,8:9,10-trimethanoanthracene-2,3,6,7-tetracarboxylic acid, decahydronaphthalene-2,3,6,7-tetracarboxylic acid, decahydro-1,4:5,8-dimethanonaphthalene-2,3,6,7-tetracarboxylic acid, decahydro-1,4-ethano-5,8-methanonaphthalene-2,3,6,7-tetracarboxylic acid, norbornane-2-spiro-α-cyclopentanone-α'-spiro-2"-norbornane-5,5",6,6"-tetracarboxylic acid (also known as "norbornane-2-spiro-2'-cyclopentanone-5'-spiro-2"-norbornane-5,5',6,6"-tetracarboxylic acid"), methylnorbornane-2-spiro-α-cyclopentanone-α'-spiro-2 " - (methylnorbornane)-5,5',6,6"-tetracarboxylic acid, norbornane-2-spiro-α-cyclohexanone-α'-spiro-2"-norbornane-5,5",6,6"-tetracarboxylic acid (also known as "norbornane-2-spiro-2'-cyclohexanone-6'-spiro-2"-norbornane-5,5',6,6"-tetracarboxylic acid"), methylnorbornane-2-spiro-α-cyclohexanone-α'-spiro-2"-(methylnorbornane)-5,5",6,6"-tetracarboxylic acid, norbornane-2-spiro-α-cyclopropanone-α'-spiro-2"-norbornane-5,5",6,6"-tetracarboxylic acid, norbornane-2-spiro-α-cyclobutanone-α'-spiro-2"-norbornane-5,5",6,6"-tetracarboxylic acid, norbornane-2-spiro-α-cycloheptanone-α'-spiro-2"-norbornane-5,5",6,6"-tetracarboxylic acid, norbornane-2-spiro-α-cyclooctanone-α'-spiro-2"-norbornane-5,5",6,6"-tetracarboxylic acid, norbornane-2-spiro-α-cyclononanone-α'-spiro-2"-norbornane-5,5",6,6"-tetracarboxylic acid, norbornane-2-spiro-α-cyclodecanone-α'-spiro-2"-norbornane-5,5",6,6"-tetracarboxylic acid, norbornane-2-spiro-α-cycloundecanone-α'-spiro-2"-norbornane-5,5",6,6"-tetracarboxylic acid, norbornane-2-spiro-α-cyclododecanone-α'-spiro-2"-norbornane-5,5",6,6"-tetracarboxylic acid, norbornane-2-spiro-α-cyclotridecanone-α'-spiro-2"-norbornane-5,5",6,6"-tetracarboxylic acid, norbornane-2-spiro-α-cyclotetradecanone-α'-spiro-2"-norbornane-5,5",6,6"-tetracarboxylic acid, norbornane-2-spiro-α-cyclopentadecanone-α'-spiro-2"-norbornane-5,5",6,6"-tetracarboxylic acid, norbornane-2-spiro-α-(methylcyclopentanone)-α'-spiro-2"-norbornane-5,5",6,6"-tetracarboxylic acid, and norbornane-2-spiro-α-(methylcyclohexanone)-α'-spiro-2"-norbornane-5,5",6,6"-tetracarboxylic acid, and acid anhydrides thereof. Among these, dianhydrides having two acid anhydride structures are suitable, particularly 1,2,3,4-cyclobutanetetracarboxylic dianhydride, 1,2,3,4-cyclohexanetetracarboxylic dianhydride, and 1,2,4,5-cyclohexanetetracarboxylic dianhydride are preferable, 1,2,3,4-cyclobutanetetracarboxylic dianhydride and 1,2,4,5-cyclohexanetetracarboxylic dianhydride are more preferable, and 1,2,3,4-cyclobutanetetracarboxylic dianhydride is still more preferable. These may be used singly or in combination of two or more kinds thereof. For obtaining high transparency, the amount of the aromatic tetracarboxylic acids copolymerized is, for example, preferably 50% by mass or more, more preferably 60% by mass or more, still more preferably 70% by mass or more, yet still more preferably 80% by mass or more of the total amount of all the tetracarboxylic acids.

Examples of the tricarboxylic acids include aromatic tricarboxylic acids such as trimellitic acid, 1,2,5-naphthalenetricarboxylic acid, diphenyl ether-3,3',4'-tricarboxylic acid, and diphenylsulfone-3,3',4'-tricarboxylic acid, or hydrogenated products of the aromatic tricarboxylic acids such as hexahydrotrimellitic acid, and alkylene glycol bistrimellitates such as ethylene glycol bistrimellitate, propylene glycol bistrimellitate, 1,4-butanediol bistrimellitate, and polyethylene glycol bistrimellitate and monoanhydrides and esterified products thereof. Among these, monoanhydrides having one acid anhydride structure are suitable, and particularly trimellitic anhydride and hexahydrotrimellitic anhydride are preferable. These may be used singly or a plurality of these may be used in combination.

Examples of the dicarboxylic acids include aromatic dicarboxylic acids such as terephthalic acid, isophthalic acid, orthophthalic acid, naphthalenedicarboxylic acid, and 4,4'-oxydibenzenecarboxylic acid, or hydrogenated products of the aromatic dicarboxylic acids such as 1,6-cyclohexanedicarboxylic acid, and oxalic acid, succinic acid, glutaric acid, adipic acid, heptanedioic acid, octanedioic acid, azelaic acid, sebacic acid, undecadic acid, dodecanedioic acid, and 2-methylsuccinic acid and acid chlorides or esterified products thereof. Among these, aromatic dicarboxylic acids and hydrogenated products thereof are suitable, and particularly terephthalic acid, 1,6-cyclohexanedicarboxylic acid, and 4,4'-oxydibenzenecarboxylic acid are preferable. The dicarboxylic acids may be used singly or a plurality of these may be used in combination.

The diamines or isocyanates for obtaining the highly colorless and transparent polyimide in the present invention are not particularly limited, and it is possible to use aromatic diamines, aliphatic diamines, alicyclic diamines, aromatic

diisocyanates, aliphatic diisocyanates, alicyclic diisocyanates and the like that are usually used in the polyimide synthesis, polyamide-imide synthesis, and polyamide synthesis. Aromatic diamines are preferable from the viewpoint of heat resistance, and alicyclic diamines are preferable from the viewpoint of transparency. When aromatic diamines having a benzoxazole structure are used, a high elastic modulus, low heat shrinkability, and a low coefficient of linear thermal expansion as well as high heat resistance can be exerted. The diamines and isocyanates may be used singly or in combination of two or more kinds thereof.

Examples of the aromatic diamines include: 2,2'-dimethyl-4,4'-diaminobiphenyl; 1,4-bis[2-(4-aminophenyl)-2-propyl]benzene; 1,4-bis(4-amino-2-trifluoromethylphenoxy)benzene; 2,2'-ditrifluoromethyl-4,4'-diaminobiphenyl; 4,4'-bis(4-aminophenoxy)biphenyl; 4,4'-bis(3-aminophenoxy)biphenyl; bis[4-(3-aminophenoxy)phenyl]ketone; bis[4-(3-aminophenoxy)phenyl]sulfide; bis[4-(3-aminophenoxy)phenyl] sulfone; 2,2-bis[4-(3-aminophenoxy)phenyl]propane; 2,2-bis[4-(3-aminophenoxy)phenyl]-1,1,1,3,3,3-hexafluoropropane; m-phenylenediamine; o-phenylenediamine; p-phenylenediamine; m-aminobenzylamine; p-aminobenzylamine; 4-amino-N-(4-aminophenyl)benzamide; 3,3'-diaminodiphenylether; 3,4'-diaminodiphenylether; 4,4'-diaminodiphenylether; 2,2'-trifluoromethyl-4,4'-diaminodiphenylether; 3,3'-diaminodiphenylsulfide; 3,4'-diaminodiphenylsulfide; 4,4'-diaminodiphenylsulfide; 3,3'-diaminodiphenylsulfoxide; 3,4'-diaminodiphenylsulfoxide; 4,4'-diaminodiphenylsulfoxide; 3,3'-diaminodiphenyl sulfone; 3,4'-diaminodiphenyl sulfone; 4,4'-diaminodiphenyl sulfone; 3,3'-diaminobenzophenone; 3,4'-diaminobenzophenone; 4,4'-diaminobenzophenone; 3,3'-diaminodiphenylmethane; 3,4'-diaminodiphenylmethane; 4,4'-diaminodiphenylmethane; bis[4-(4-aminophenoxy)phenyl]methane; 1,1-bis[4-(4-aminophenoxy)phenyl]ethane; 1,2-bis[4-(4-aminophenoxy)phenyl]ethane; 1,1-bis[4-(4-aminophenoxy)phenyl]propane; 1,2-bis[4-(4-aminophenoxy)phenyl]propane; 1,3-bis[4-(4-aminophenoxy)phenyl]propane; 2,2-bis[4-(4-aminophenoxy)phenyl]propane; 1,1-bis[4-(4-aminophenoxy)phenyl]butane; 1,3-bis[4-(4-aminophenoxy)phenyl]butane; 1,4-bis[4-(4-aminophenoxy)phenyl]butane; 2,2-bis[4-(4-aminophenoxy)phenyl]butane; 2,3-bis[4-(4-aminophenoxy)phenyl]butane; 2-[4-(4-aminophenoxy)phenyl]-2-[4-(4-aminophenoxy)-3-methylphenyl]propane; 2,2-bis[4-(4-aminophenoxy)-3-methylphenyl]propane; 2-[4-(4-aminophenoxy)phenyl]-2-[4-(4-aminophenoxy)-3,5-dimethylphenyl]propane; 2,2-bis[4-(4-aminophenoxy)-3,5-dimethylphenyl]propane; 2,2-bis[4-(4-aminophenoxy)phenyl]-1,1,1,3,3,3-hexafluoropropane; 1,4-bis(3-aminophenoxy)benzene; 1,3-bis(3-aminophenoxy)benzene; 1,4-bis(4-aminophenoxy)benzene; 4,4'-bis(4-aminophenoxy)biphenyl; bis[4-(4-aminophenoxy)phenyl]ketone; bis[4-(4-aminophenoxy)phenyl]sulfide; bis[4-(4-aminophenoxy)phenyl]sulfoxide; bis[4-(4-aminophenoxy)phenyl] sulfone; bis[4-(3-aminophenoxy)phenyl]ether; bis[4-(4-aminophenoxy)phenyl]ether; 1,3-bis[4-(4-aminophenoxy)benzoyl]benzene; 1,3-bis[4-(3-aminophenoxy)benzoyl]benzene; 1,4-bis[4-(3-aminophenoxy)benzoyl]benzene; 4,4'-bis[(3-aminophenoxy)benzoyl]benzene; 1,1-bis[4-(3-aminophenoxy)phenyl]propane; 1,3-bis[4-(3-aminophenoxy)phenyl]propane; 3,4'-diaminodiphenylsulfide; 2,2-bis[3-(3-aminophenoxy)phenyl]-1,1,1,3,3,3-hexafluoropropane; bis[4-(3-aminophenoxy)phenyl]methane; 1,1-bis[4-(3-aminophenoxy)phenyl]ethane; 1,2-bis[4-(3-aminophenoxy)phenyl]ethane; bis[4-(3-aminophenoxy)phenyl]sulfoxide; 4,4'-bis[3-(4-aminophenoxy)benzoyl]diphenylether; 4,4'-bis[3-(3-aminophenoxy)benzoyl]diphenylether; 4,4'-bis[4-(4-amino-$\alpha,\alpha$-dimethylbenzyl)phenoxy]benzophenone; 4,4'-bis[4-(4-amino-$\alpha,\alpha$-dimethylbenzyl)phenoxy]diphenyl sulfone; bis[4-{4-(4-aminophenoxy)phenoxy}phenyl] sulfone; 1,4-bis[4-(4-aminophenoxy)phenoxy-$\alpha,\alpha$-dimethylbenzyl]benzene; 1,3-bis[4-(4-aminophenoxy)phenoxy-$\alpha,\alpha$-dimethylbenzyl]benzene; 1,3-bis[4-(4-amino-6-trifluoromethylphenoxy)-$\alpha,\alpha$-dimethylbenzyl]benzene; 1,3-bis[4-(4-amino-6-fluorophenoxy)-$\alpha,\alpha$-dimethylbenzyl]benzene; 1,3-bis[4-(4-amino-6-methylphenoxy)-$\alpha,\alpha$-dimethylbenzyl]benzene; 1,3-bis[4-(4-amino-6-cyanophenoxy)-$\alpha,\alpha$-dimethylbenzyl]benzene; 3,3'-diamino-4,4'-diphenoxybenzophenone; 4,4'-diamino-5,5'-diphenoxybenzophenone; 3,4'-diamino-4,5'-diphenoxybenzophenone; 3,3'-diamino-4-phenoxybenzophenone; 4,4'-diamino-5-phenoxybenzophenone, 3,4'-diamino-4-phenoxybenzophenone; 3,4'-diamino-5'-phenoxybenzophenone; 3,3'-diamino-4,4'-dibiphenoxybenzophenone; 4,4'-diamino-5,5'-dibiphenoxybenzophenone; 3,4'-diamino-4,5'-dibiphenoxybenzophenone; 3,3'-diamino-4-biphenoxybenzophenone; 4,4'-diamino-5-biphenoxybenzophenone; 3,4'-diamino-4-biphenoxybenzophenone; 3,4'-diamino-5'-biphenoxybenzophenone; 1,3-bis(3-amino-4-phenoxybenzoyl)benzene; 1,4-bis(3-amino-4-phenoxybenzoyl)benzene; 1,3-bis(4-amino-5-phenoxybenzoyl)benzene; 1,4-bis(4-amino-5-phenoxybenzoyl)benzene; 1,3-bis(3-amino-4-biphenoxybenzoyl)benzene, 1,4-bis(3-amino-4-biphenoxybenzoyl)benzene; 1,3-bis(4-amino-5-biphenoxybenzoyl)benzene; 1,4-bis(4-amino-5-biphenoxybenzoyl)benzene; 2,6-bis[4-(4-amino-$\alpha,\alpha$-dimethylbenzyl)phenoxy]benzonitrile; 4,4'-[9H-fluorene-9,9-diyl]bisaniline (also known as "9,9-bis(4-aminophenyl)fluorene"); spiro(xanthene-9,9'-fluorene)-2,6-diyl bis(oxycarbonyl)]bisaniline; 4,4'-[spiro(xanthene-9,9'-fluorene)-2,6-diyl bis(oxycarbonyl)]bisaniline; and 4,4'-[spiro(xanthene-9,9'-fluorene)-3,6-diyl bis(oxycarbonyl)]bisaniline. A part or all of hydrogen atoms on an aromatic ring of the above-described aromatic diamines may be substituted with halogen atoms; alkyl groups or alkoxyl groups having 1 to 3 carbon atoms; or cyano groups, and further a part or all of hydrogen atoms of the alkyl groups or alkoxyl groups having 1 to 3 carbon atoms may be substituted with halogen atoms. The aromatic diamines having a benzoxazole structure are not particularly limited, and examples thereof include: 5-amino-2-(p-aminophenyl)benzoxazole; 6-amino-2-(p-aminophenyl)benzoxazole; 5-amino-2-(m-aminophenyl)benzoxazole; 6-amino-2-(m-aminophenyl)benzoxazole; 2,2'-p-phenylenebis(5-aminobenzoxazole); 2,2'-p-phenylenebis(6-aminobenzoxazole); 1-(5-aminobenzoxazolo)-4-(6-aminobenzoxazolo)benzene; 2,6-(4,4'-diaminodiphenyl)benzo[1,2-d:5,4-d']bisoxazole; 2,6-(4,4'-diaminodiphenyl)benzo[1,2-d:4,5-d']bisoxazole; 2,6-(3,4'-diaminodiphenyl)benzo[1,2-d:5,4-d']bisoxazole; 2,6-(3,4'-diaminodiphenyl)benzo[1,2-d:4,5-d']bisoxazole; 2,6-(3,3'-diaminodiphenyl)benzo[1,2-d:5,4-d']bisoxazole; and 2,6-(3,3'-diaminodiphenyl)benzo[1,2-d:4,5-d']bisoxazole. Among these, particularly 2,2'-ditrifluoromethyl-4,4'-diaminobiphenyl, 4-amino-N-(4-aminophenyl)benzamide, 4,4'-diaminodiphenyl sulfone, and 3,3'-diaminobenzophenone are preferable. The aromatic diamines may be used singly or a plurality of these may be used in combination.

Examples of the alicyclic diamines include 1,4-diaminocyclohexane, 1,4-diamino-2-methylcyclohexane, 1,4-diamino-2-ethylcyclohexane, 1,4-diamino-2-n-propylcyclohexane, 1,4-diamino-2-isopropylcyclohexane, 1,4-diamino-2-n-butylcyclohexane, 1,4-diamino-2-isobutylcyclohexane, 1,4-diamino-2-sec-butylcyclohexane, 1,4-diamino-2-tert-butylcyclohexane, and 4,4'-methylenebis(2,6-dimethylcyclohexylamine). Among these, particularly 1,4-diaminocyclohexane and 1,4-diamino-2-methylcyclohexane are preferable, and 1,4-diaminocyclohexane is more preferable. The alicyclic diamines may be used singly or a plurality of these may be used in combination.

Examples of the diisocyanates include aromatic diisocyanates such as diphenylmethane-2,4'-diisocyanate, 3,2'- or 3,3'- or 4,2'- or 4,3'- or 5,2'- or 5,3'- or 6,2'- or 6,3'-dimethyldiphenylmethane-2,4'-diisocyanate, 3,2'- or 3,3'- or 4,2'- or 4,3'- or 5,2'- or 5,3'- or 6,2'- or 6,3'-diethyldiphenylmethane-2,4'-diisocyanate, 3,2'- or 3,3'- or 4,2'- or 4,3'- or 5,2'- or 5,3'- or 6,2'- or 6,3'-dimethoxydiphenylmethane-2,4'-diisocyanate, diphenylmethane-4,4'-diisocyanate, diphenylmethane-3,3'-diisocyanate, diphenylmethane-3,4'-diisocyanate, diphenyl ether-4,4'-diisocyanate, benzophenone-4,4'-diisocyanate, diphenylsulfone-4,4'-diisocyanate, tolylene-2,4-diisocyanate, tolylene-2,6-diisocyanate, m-xylylene diisocyanate, p-xylylene diisocyanate, naphthalene-2,6-diisocyanate, 4,4'-(2,2 bis(4-phenoxyphenyl)propane)diisocyanate, 3,3'- or 2,2'-dimethylbiphenyl-4,4'-diisocyanate, 3,3'- or 2,2'-diethylbiphenyl-4,4'-diisocyanate, 3,3'-dimethoxybiphenyl-4,4'-diisocyanate, and 3,3'-diethoxybiphenyl-4,4'-diisocyanate, and hydrogenated diisocyanates of any of these (for example, isophorone diisocyanate, 1,4-cyclohexane diisocyanate, 1,3-cyclohexane diisocyanate, 4,4'-dicyclohexylmethane diisocyanate, and hexamethylene diisocyanate). Among these, diphenylmethane-4,4'-diisocyanate, tolylene-2,4-diisocyanate, tolylene-2,6-diisocyanate, 3,3'-dimethylbiphenyl-4,4'-diisocyanate, naphthalene-2,6-diisocyanate, 4,4'-dicyclohexylmethane diisocyanate, and 1,4-cyclohexane diisocyanate are preferable from the viewpoint of low moisture absorption property, dimensional stability, price, and polymerizability. The diisocyanates may be used singly or a plurality of these may be used in combination.

The highly heat-resistant transparent film of the present invention may have a single-layer structure or a laminated configuration of two or more layers. For the physical strength of the highly heat-resistant transparent film and the ease of peeling off of the highly heat-resistant transparent film from the inorganic substrate, the highly heat-resistant transparent film preferably has a laminated configuration of two or more layers and may have a laminated configuration of three or more layers. In the present specification, the physical properties (yellowness index, total light transmittance, haze, and the like) of the highly heat-resistant transparent film in the case of having a laminated configuration of two or more layers refer to the values for the entire highly heat-resistant transparent film unless otherwise stated.

The yellowness index (hereafter, also referred to as "yellow index" or "YI") of the highly heat-resistant transparent film in the present invention is preferably 10 or less, more preferably 7 or less, still more preferably 5 or less, yet still more preferably 3 or less. The lower limit of the yellowness index of the highly heat-resistant transparent film is not particularly limited, but is preferably 0.1 or more, more preferably 0.2 or more, still more preferably 0.3 or more for use as a flexible electronic device.

The light transmittance of the highly heat-resistant transparent film at a wavelength of 400 nm in the present invention is preferably 70% or more, more preferably 72% or more, still more preferably 75% or more, yet still more preferably 80% or more. The upper limit of the light transmittance of the highly heat-resistant transparent film at a wavelength of 400 nm is not particularly limited, but is preferably 99% or less, more preferably 98% or less, still more preferably 97% or less for use as a flexible electronic device.

The total light transmittance of the highly heat-resistant transparent film in the present invention is preferably 75% or more, more preferably 85% or more, still more preferably 87% or more, yet still more preferably 88% or more. The upper limit of the total light transmittance of the highly heat-resistant transparent film is not particularly limited, but is preferably 98% or less, more preferably 97% or less for use as a flexible electronic device.

The haze of the highly heat-resistant transparent film in the present invention is preferably 1.0 or less, more preferably 0.8 or less, still more preferably 0.5 or less, yet still more preferably 0.3 or less.

The thickness direction retardation (Rth) of the highly heat-resistant transparent film in the present invention is preferably 500 nm or less, more preferably 300 nm or less, still more preferably 200 nm or less, yet still more preferably 100 nm or less. The lower limit of Rth of the highly heat-resistant transparent film is not particularly limited, but is preferably 0.1 nm or more, more preferably 0.5 nm or more for use as a flexible electronic device.

The thickness of the highly heat-resistant transparent film in the present invention is preferably 5 um or more, more preferably 8 μm or more, still more preferably 15 um or more, yet still more preferably 20 μm or more. The upper limit of the thickness of the highly heat-resistant transparent film is not particularly limited but is preferably 200 μm or less, more preferably 150 um or less, still more preferably 90 um or less for use as a flexible electronic device. It is difficult to fabricate and transport the film when the thickness is too thin, and it is difficult to transport the roll when the thickness is too thick.

The highly colorless and transparent polyimide film having the coefficient of linear thermal expansion (CTE) of the present invention can be realized by performing stretching in the course of forming the polyimide film. Such stretching operation can be realized by performing stretching by 1.5-fold to 4.0-fold in the MD direction and 1.4-fold to 3.0-fold in the TD direction in the course of applying a polyimide solution to a support for polyimide film fabrication, drying the solution to form a polyimide film containing a solvent at 1% to 50% by mass, and further treating the polyimide film containing a solvent at 1% to 50% by mass at a high temperature on the support for polyimide film fabrication or in a state of being peeled off from the support for drying. At this time, by stretching the thermoplastic polymer film and the polyimide film at the same time using an unstretched thermoplastic polymer film as the support for polyimide film fabrication and then peeling off the stretched polyimide film from the thermoplastic polymer film, it is possible to prevent the polyimide film from being scratched at the time of stretching in the MD direction and to obtain a highly colorless and transparent polyimide film with higher quality.

The average coefficient of linear thermal expansion (CTE) of the highly heat-resistant transparent film at between 30°C and 300°C is preferably 50 ppm/K or less. The CTE is more preferably 45 ppm/K or less, more preferably 40 ppm/K or less, still more preferably 30 ppm/K or less, particularly preferably 20 ppm/K or less. The CTE is preferably -5 ppm/K or more, more preferably -3 ppm/K or more, still more preferably 1 ppm/K or more. When the CTE is in the above range, a small difference in coefficient of linear thermal expansion between the highly heat-resistant transparent film and a general support (inorganic substrate) can be maintained, and the highly heat-resistant transparent film and the inorganic substrate can be prevented from peeling off from each other or warping together with the support when being subjected to a process of applying heat as well. Here, CTE is a factor that indicates reversible expansion and contraction with respect to temperature. The CTE of the highly heat-resistant transparent film refers to the average value of the CTE in the machine direction (MD direction) and the CTE in the transverse direction (TD direction) of the highly heat-resistant transparent film. The method for measuring the CTE of the highly heat-resistant transparent film is as described in Examples.

The highly heat-resistant transparent film can contain a filler. The filler is not particularly limited, and examples thereof include silica, carbon, and ceramic, and silica is preferable among these. These fillers may be used singly or two or more kinds thereof may be used concurrently. By adding a filler, protrusions are imparted to the highly heat-resistant transparent film surface, and this increases the slipperiness of the highly heat-resistant transparent film surface. By adding a filler, the CTE and Rth of the highly heat-resistant transparent film can be suppressed to low levels. The average particle size of filler is preferably 1 nm or more, more preferably 5 nm or more, still more preferably 10 nm or more, particularly preferably 30 nm or more. The average particle size of filler is preferably 1 μm or less, more preferably 500 nm or less, still more preferably 100 nm or less.

The content of filler in the highly heat-resistant transparent film is preferably adjusted depending on the average particle size of filler. When the particle size of filler is 30 nm or more, the content of filler is preferably 0.01% to 5% by mass, more preferably 0.02% to 3% by mass, still more preferably 0.05% to 2% by mass, particularly preferably 0.1% to 1% by mass. Meanwhile, when the particle size of filler is less than 30 nm, the content of filler is preferably 1% to 50% by mass, more preferably 3% to 40% by mass, still more preferably 5% to 30% by mass, particularly preferably 10% to 20% by mass. By adjusting the content in the above range, high slipperiness of the highly heat-resistant transparent film surface can be maintained without impairing the transparency of the highly heat-resistant transparent film, and the CTE and Rth of the highly heat-resistant transparent film can be suppressed to low levels.

The method for adding a filler to the highly heat-resistant transparent film is not particularly limited, but examples thereof include a method in which the filler is added as a powder and a method in which the filler is added in the form of filler/solvent (slurry) when or after the above-mentioned polyamic acid (polyimide precursor) solution, polyimide solution, polyamide-imide solution, or polyamide solution is prepared, and the method in which the filler is added as a slurry is particularly preferable among others. The slurry is not particularly limited, but examples thereof include a slurry in which silica having an average particle size of 10 nm is dispersed in N,N-dimethylacetamide (DMAC) at a concentration of 20% by mass (for example, "SNOWTEX (registered trademark) DMAC-ST" manufactured by Nissan Chemical Corporation) and a slurry in which silica having an average particle size of 80 nm is dispersed in N,N-dimethylacetamide (DMAC) at a concentration of 20% by mass (for example, "SNOWTEX (registered trademark) DMAC-ST-ZL" manufactured by Nissan Chemical Corporation).

When the highly heat-resistant transparent film has a laminated configuration of two or more layers, it is not preferable that the differences in CTE between the respective layers are different from one another since the difference causes warpage. Hence, the difference in CTE between the first highly heat-resistant transparent film layer that is in contact with the inorganic substrate and the second highly heat-resistant transparent film layer that is not in contact with the inorganic substrate but is adjacent to the first highly heat-resistant transparent film is preferably 40 ppm/K or less, more preferably 30 ppm/K or less, still more preferably 15 ppm/K or less. In particular, it is preferable that the layer having the thickest film thickness of the second highly heat-resistant transparent film is within the above range. It is preferable that the highly heat-resistant transparent film has a symmetrical structure in the film thickness direction since warpage is unlikely to occur.

The CTE of the first highly heat-resistant transparent film singly is preferably 20 ppm/K or less. Since the difference in CTE between the first highly heat-resistant transparent film and the inorganic substrate becomes small, the CTE is more preferably 15 ppm/K or less, still more preferably 10 ppm/K or less. The lower limit of the CTE is not particularly limited, but is preferably -10 ppm/K or more, more preferably -5 ppm/K or more, still more preferably 1 ppm/K or more for use as a flexible electronic device. The CTE of the first highly heat-resistant transparent film refers to the average value of the CTE in the machine direction (MD direction) and the CTE in the transverse direction (TD direction) of the highly heat-resistant transparent film. The method for measuring the CTE of the first highly heat-resistant transparent film is as described in Examples.

It is preferable that the first highly heat-resistant transparent film is transparent polyimide. When the second highly heat-resistant transparent film further has a plurality of laminated configurations, it is preferable that at least one layer of the second highly heat-resistant transparent film is transparent polyimide, and it is more preferable that the layer having the thickest film thickness of the second highly heat-resistant transparent film is transparent polyimide. Still more preferably, all layers of the second highly heat-resistant transparent polyimide are transparent polyimide.

It is preferable that the first highly heat-resistant transparent film layer that is in contact with the inorganic substrate contains polyimide having the structure represented by the following Formula 1 and/or the structure represented by the following Formula 2. The total amount of polyimides having the structures represented by Formulas 1 and 2 in the first highly heat-resistant transparent film layer is preferably 70% by mass or more, more preferably 80% by mass or more, still more preferably 90% by mass or more, particularly preferably 95% by mass or more, and may be 100% by mass or more. By containing polyimide having the structure represented by Formula 1 and/or the structure represented by Formula 2 within the above range, the first highly heat-resistant transparent film can exert an excellent CTE.

[Formula 1]

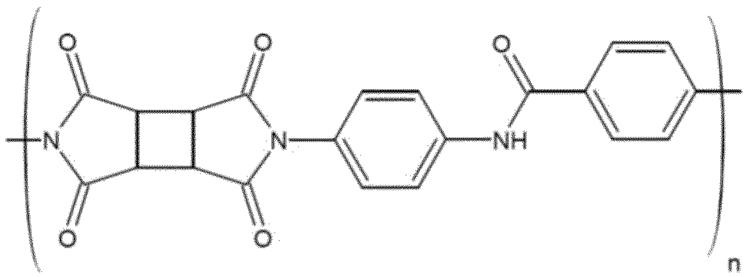

[Formula 2]

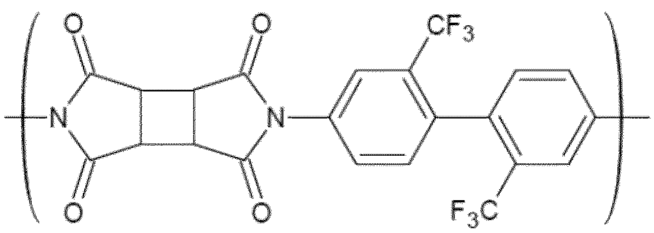

The heat shrinkage rate of the highly heat-resistant transparent film at between 30°C and 500°C is preferably ± 0.9%, still more preferably ± 0.6%. The heat shrinkage rate is a factor that represents irreversible expansion and contraction with respect to the temperature.

The tensile breaking strength of the highly heat-resistant transparent film is preferably 60 MPa or more, more preferably 120 MPa or more, still more preferably 240 MPa or more. The upper limit of the tensile breaking strength is not particularly limited but is practically less than about 1000 MPa. When the tensile breaking strength is 60 MPa or more, it is possible to prevent the highly heat-resistant transparent film from breaking when being peeled off from the inorganic substrate. The tensile breaking strength of the highly heat-resistant transparent film refers to the average value of the tensile breaking strength in the machine direction (MD direction) and the tensile breaking strength in the transverse direction (TD direction) of the highly heat-resistant transparent film. The method for measuring the tensile breaking strength of the highly heat-resistant transparent film is as described in Examples. When the highly heat-resistant transparent film is fabricated after application onto a glass substrate has been performed using a casting applicator as well,

orthogonal two directions of the parallel direction and vertical direction to the application using a casting applicator are defined as (MD direction) and (TD direction), respectively. Hereinafter, the same applies to the tensile breaking elongation and the tensile elasticity as well.

The tensile breaking elongation of the highly heat-resistant transparent film is preferably 1% or more, more preferably 5% or more, still more preferably 20% or more. When the tensile breaking elongation is 1% or more, the handleability is excellent. The tensile breaking strength of the highly heat-resistant transparent film refers to the average value of the tensile breaking strength in the machine direction (MD direction) and the tensile breaking strength in the transverse direction (TD direction) of the highly heat-resistant transparent film. The method for measuring the tensile breaking strength of the highly heat-resistant transparent film is as described in Examples.

The tensile elasticity of the highly heat-resistant transparent film is preferably 2 GPa or more, more preferably 3 GPa or more, still more preferably 4 GPa or more. When the tensile elasticity is 3 GPa or more, the highly heat-resistant transparent film is less expanded and deformed when being peeled off from the inorganic substrate and exhibits excellent handleability. The tensile elasticity is preferably 20 GPa or less, more preferably 12 GPa or less, still more preferably 10 GPa or less. When the tensile elasticity is 20 GPa or less, the highly heat-resistant transparent film can be used as a flexible film. The tensile elasticity of the highly heat-resistant transparent film refers to the average value of the tensile elasticity in the machine direction (MD direction) and the tensile elasticity in the transverse direction (TD direction) of the highly heat-resistant film. The method for measuring the tensile elasticity of the highly heat-resistant transparent film is as described in Examples.

Unevenness of the thickness of the highly heat-resistant transparent film is preferably 20% or less, more preferably 12% or less, still more preferably 7% or less, particularly preferably 4% or less. When the evenness of the thickness exceeds 20%, the polyimide film tends to be hardly applied to a narrow part. Unevenness of the thickness of the highly heat-resistant transparent film can be determined, for example, based on the following equation from the film thicknesses, which are measured at about 10 randomly extracted locations of the film to be measured using a contact-type film thickness meter.

$$\text{Unevenness of thickness of film (\%)} = 100 \times (\text{maximum film thickness} - \text{minimum film thickness}) \div \text{average film thickness}$$

The highly heat-resistant transparent film is preferably obtained in the form of being wound as a long highly heat-resistant transparent film having a width of 300 mm or more and a length of 10 m or more at the time of production, more preferably in the form of a roll-shaped highly heat-resistant transparent film wound around a winding core. When the highly heat-resistant transparent film is wound in a roll shape, it is easy to transport the highly heat-resistant transparent film in the form of a film wound in a roll shape.

In order to secure handleability and productivity of the highly heat-resistant transparent film, a lubricant (particles) having a particle size of about 10 to 1000 nm is preferably added to/contained in the highly heat-resistant transparent film at about 0.03% to 3% by mass to impart fine irregularities to the highly heat-resistant transparent film surface and secure slipperiness.

In the highly heat-resistant transparent film having a laminated configuration of two or more layers, it is particularly desirable that there is little intermingling between the first highly heat-resistant transparent film layer that is in contact with the inorganic substrate and the second highly heat-resistant transparent film layer that is adjacent to the first highly heat-resistant transparent film layer (hereinafter, also simply referred to as "second highly heat-resistant transparent film layer") at the interface. Since it is easy to thin the highly heat-resistant transparent film when the thickness of intermingling is thin, the thickness of intermingling is preferably 800 nm or less, more preferably 500 nm or less, still more preferably 200 nm or less, yet still more preferably 100 nm or less, particularly preferably 50 nm or less. When the thickness of intermingling is too thick, intermingling possibly occurs on the outermost surface of the highly heat-resistant transparent film, and this may make it difficult to thin the film. The lower limit is not particularly limited, but industrially, there is no problem when the thickness of intermingling is 10 nm or more, and the thickness of intermingling may be 20 nm or more.

The means for forming less intermingled layers is not particularly limited, but it is preferable to fabricate either one of the first highly heat-resistant transparent film layer or the second highly heat-resistant transparent film layer, to perform a heating step, and then to fabricate the next layer rather than to fabricate two layers of the first highly heat-resistant transparent film layer and the second highly heat-resistant transparent film layer simultaneously by solution film formation. The expression 'after the heating step is performed' includes both a case in the middle of the heating step and a case where the heating step is completed. Less intermingled layers are formed when the next layer is

fabricated after the heating step has been completed, but the surface of the finished film is often already unreactive and has fewer functional groups, thus the adhesive strength between the two layers is weak, and practical problems may occur. For this reason, it is desirable to have an interface where intermingling occurs by 10 nm or more even when little intermingling occurs.

By forming materials (resins) exhibiting different physical properties into a film having a two-layer configuration, it is possible to fabricate a film exhibiting various properties at the same time. Furthermore, by laminating the layers into a symmetrical structure in the thickness direction (for example, first highly heat-resistant transparent film layer/second highly heat-resistant transparent film layer/first highly heat-resistant transparent film layer), the CTE balance in the entire film is improved and the film that is unlikely to undergo warpage can be fabricated. It is conceivable to impart features to the spectral characteristics by forming any one of the layers as a layer that absorbs ultraviolet rays or infrared rays, and to control the incidence and emission of light by layers having different refractive indexes.

As a means for fabricating a film having a layer configuration of two or more layers, various methods such as simultaneous application using a T-die capable of simultaneously discharging two layers, sequential application in which one layer is applied and then the next layer is applied, a method in which one layer is applied and then dried, and then the next layer is applied, a method in which the next layer is applied after the film formation of one layer has been finished, or multilayering by heat lamination using a thermoplastic layer inserted between layers are conceivable. However, in the present patent, various existing application methods and multilayering methods can be appropriately incorporated.

The thickness of the first highly heat-resistant transparent film is preferably 0.1 μm or more. The thickness of the first highly heat-resistant transparent film is more preferably 0.4 μm or more, still more preferably 1 um or more, yet still more preferably 2 μm or more, particularly preferably 3 um or more from the viewpoint of being less affected by intermingling. The thickness of the first highly heat-resistant transparent film is preferably 10 um or less, more preferably 8 μm or less, still more preferably 5 um or less from the viewpoint of thinning the entire highly heat-resistant transparent film.

<Inorganic substrate>

The inorganic substrate may be a plate-type substrate which can be used as a substrate made of an inorganic substance, and examples thereof include those mainly composed of glass plates, ceramic plates, semiconductor wafers, metals and the like and those in which these glass plates, ceramic plates, semiconductor wafers, and metals are laminated, those in which these are dispersed, and those in which fibers of these are contained as the composite of these.

Examples of the glass plates include quartz glass, high silicate glass (96% silica), soda lime glass, lead glass, aluminoborosilicate glass, and borosilicate glass (Pyrex (registered trademark)), borosilicate glass (alkali-free), borosilicate glass (microsheet), aluminosilicate glass and the like. Among these, those having a coefficient of linear thermal expansion of 5 ppm/K or less are desirable, and in the case of a commercially available product, "Corning (registered trademark) 7059", "Corning (registered trademark) 1737", and "EAGLE" manufactured by Corning Inc., "AN100" manufactured by AGC Inc., "OA10" and "OA11G" manufactured by Nippon Electric Glass Co., Ltd., "AF32" manufactured by SCHOTT AG, and the like that are glass for liquid crystal are desirable.

The semiconductor wafer is not particularly limited, but examples thereof include a silicon wafer and wafers of germanium, silicon-germanium, gallium-arsenide, aluminum-gallium-indium, nitrogen-phosphorus-arsenic-antimony, SiC, InP (indium phosphide), InGaAs, GaInNAs, LT, LN, ZnO (zinc oxide), CdTe (cadmium telluride), ZnSe (zinc selenide) and the like. Among these, the wafer preferably used is a silicon wafer, and a mirror-polished silicon wafer having a size of 8 inches or more is particularly preferable.

The metals include single element metals such as W, Mo, Pt, Fe, Ni, and Au, alloys such as Inconel, Monel, Nimonic, carbon-copper, Fe-Ni-based Invar alloy, and Super Invar alloy, and the like. Multilayer metal plates formed by adding another metal layer or a ceramic layer to these metals are also included. In this case, when the overall coefficient of linear thermal expansion (CTE) with the additional layer is low, Cu, Al and the like are also used in the main metal layer. The metals used as the addition metal layer is not limited as long as they are those that strengthen the close contact property with the highly heat-resistant film, those that exhibit properties such as no diffusion and favorable chemical resistance and heat resistance, but suitable examples thereof include Cr, Ni, TiN, and Mo-containing Cu.

Examples of the ceramic plate in the present invention include ceramics for base such as $Al_2O_3$, mullite, AlN, SiC, crystallized glass, cordierite, spodumene, Pb-BSG+CaZrO3+$Al_2O_3$, crystallized glass+$Al_2O_3$, crystallized Ca-BSG, BSG+Quartz, BSG+ quartz, BSG+$Al_2O_3$, Pb-BSG+$Al_2O_3$, glass-ceramic, and zerodur material.

It is desirable that the flat portion of the inorganic substrate is sufficiently flat. Specifically, the P-V value of the surface roughness is 50 nm or less, more preferably 20 nm or less, still more preferably 5 nm or less. When the surface is coarser than this, the peel strength between the highly heat-resistant transparent film layer and the inorganic substrate may be insufficient.

The thickness of the inorganic substrate is not particularly limited, but a thickness of 10 mm or less is preferable, a thickness of 3 mm or less is more preferable, and a thickness of 1.3 mm or less is still more preferable from the

viewpoint of handleability. The lower limit of the thickness is not particularly limited but is preferably 0.07 mm or more, more preferably 0.15 mm or more, and further preferably 0.3 mm or more. When the inorganic substrate is too thin, the inorganic substrate is easily destroyed and it is difficult to handle the inorganic substrate. When the inorganic substrate is too thick, the inorganic substrate is heavy and it is difficult to handle the inorganic substrate.

<Laminate>

The laminate of the present invention is obtained by laminating the highly heat-resistant transparent film and the inorganic substrate substantially without using an adhesive. In a case where the highly heat-resistant transparent film has a laminated configuration of two or more layers, it is preferable that the highly heat-resistant transparent film includes a first highly heat-resistant transparent film layer that is in contact with the inorganic substrate and a second highly heat-resistant transparent film layer that is not in contact with the inorganic substrate but is adjacent to the first highly heat-resistant transparent film layer. The second highly heat-resistant transparent film may further have a plurality of laminated configurations. In the thickness direction of the laminate, the laminate may have a configuration in which both ends are the inorganic substrate (for example, inorganic substrate/first highly heat-resistant transparent film/second highly heat-resistant transparent film/first highly heat-resistant transparent film/inorganic substrate). In this case, an adhesive is substantially not used for the highly heat-resistant transparent film and the inorganic substrate at both ends.

The shape of the laminate is not particularly limited and may be square or rectangular. The shape of the laminate is preferably rectangular, and the length of the long side is preferably 300 mm or more, more preferably 500 mm or more, still more preferably 1000 mm or more. The upper limit is not particularly limited, but it is desirable that the laminate replaces a substrate, which has an industrially used size and is formed from an industrially used material. A length of 20000 mm or less is sufficient, and the length of the long side may be 10000 mm or less.

It is preferable that the laminate of the present invention is warped in an amount of 10 mm or less when heated at 300°C. The warped amount is more preferably 8 mm or less, still more preferably 6 mm or less since the heat resistance is improved. The lower limit of the warped amount is not particularly limited, but industrially, a warped amount of 0.01 mm or more is sufficient, and the warped amount may be 0.1 mm or more.

<Adhesive>

An adhesive layer is substantially not interposed between the inorganic substrate and the highly heat-resistant transparent film of the present invention. Here, the adhesive layer referred to in the present invention refers to a layer containing a Si (silicon) component at less than 10% as a mass ratio (less than 10% by mass). Substantially not used (not interposed) means that the thickness of the adhesive layer interposed between the inorganic substrate and the highly heat-resistant transparent film is preferably 0.4 μm or less, more preferably 0.1 um or less, still more preferably 0.05 um or less, particularly preferably 0.03 μm or less, most preferably 0 μm.

<Silane coupling agent (SCA)>

In the laminate, it is preferable to have a layer of a silane coupling agent between the highly heat-resistant transparent film and the inorganic substrate. In the present invention, the silane coupling agent refers to a compound containing a Si (silicon) component at 10% by mass or more. Further, it is preferable to have an alkoxy group in the structure. It is desirable not to contain a methyl group in the structure. By using the silane coupling agent layer, the intermediate layer between the highly heat-resistant transparent film and the inorganic substrate can be thinned, and thus there are effects that the amount of degassed components during heating is small, elution hardly occurs in the wet process as well, and only a trace amount of components are eluted even if elution occurs. The silane coupling agent preferably contains a large amount of silicon oxide component since the heat resistance is improved, and is particularly preferably one exhibiting heat resistance at a temperature of about 400°C. The thickness of the silane coupling agent layer is preferably less than 0.2 um. As a range for use as a flexible electronic device, the thickness of the silane coupling agent layer is preferably 100 nm or less (0.1 μm or less), more desirably 50 nm or less, still more desirably 10 nm. When a silane coupling agent layer is normally fabricated, the thickness thereof is about 0.10 μm or less. In processes where it is desired to use as little silane coupling agent as possible, a silane coupling agent layer having a thickness of 5 nm or less can also be used. There is the possibility that the peel strength decreases or some parts are not be attached when the thickness is 1 nm or less, and it is thus desirable that the thickness of the silane coupling agent layer is 1 nm or more.

The silane coupling agent in the present invention is not particularly limited, but one having an amino group or an epoxy group is preferable. Specific examples of the silane coupling agent include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilanevinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-phenyl-3-aminopropyltrimethoxysilane, N-(vinylbenzyl)-2-aminoethyl-3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, 3-isocyanatepropyltriethoxysilane, tris-(3-trimethoxysilylpropyl)isocyanurate, chloromethylphenetyltrimethoxysilane, and chloromethyltrimethoxysilane. Among these, preferred examples include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, aminophenyltrimethoxysilane, aminophenetyltrimethoxysilane, and aminophenylaminomethylphenetyltrimethoxysilane. When heat resistance is required in the process, a silane coupling agent, in which Si and an amino group or the like is linked to each other via an aromatic, is desirable.

It is required that the peel strength between the highly heat-resistant transparent film and the inorganic substrate is 0.3 N/cm or less. This makes it remarkably easy to peel off the highly heat-resistant transparent film from the inorganic substrate after a device is formed on the highly heat-resistant transparent film. Hence, it is possible to manufacture a device connected body that can be produced in a large quantity and it is easy to manufacture a flexible electronic device. The peel strength is preferably 0.25 N/cm or less, more preferably 0.2 N/cm or less, still more preferably 0.15 N/cm or less, particularly preferably 0.12 N/cm or less. The peel strength is preferably 0.03 N/cm or more. The peel strength is more preferably 0.06 N/cm or more, still more preferably 0.08 N/cm or more, particularly preferably 0.1 N/cm or more since the laminate does not peel off when a device is formed on the highly heat-resistant transparent film. The peel strength is a value of the laminate after the highly heat-resistant transparent film and the inorganic substrate are bonded together and then heat-treated at 100°C for 10 minutes in an atmospheric ambience (initial peel strength). It is preferable that the peel strength of a laminate obtained by further heat-treating the laminate at the time of initial peel strength measurement at 300°C for 1 hour in a nitrogen ambience is also within the above range (peeling strength after heat treatment at 300°C).

The laminate of the present invention can be fabricated, for example, according to the following procedure. The laminate can be obtained by treating at least one surface of the inorganic substrate with a silane coupling agent in advance, superposing the surface treated with a silane coupling agent and the highly heat-resistant transparent film, and laminating the inorganic substrate and the highly heat-resistant transparent film by pressurization. The laminate can be obtained by treating at least one surface of the highly heat-resistant transparent film with a silane coupling agent in advance, superposing the surface treated with a silane coupling agent and the inorganic substrate, and laminating the highly heat-resistant transparent film and the inorganic substrate by pressurization. When the highly heat-resistant transparent film has a laminated configuration of two or more layers, and it is preferable that the first highly heat-resistant transparent film is superposed on the inorganic substrate. Examples of the pressurization method include normal pressing or lamination in the atmosphere or pressing or lamination in a vacuum. Lamination in the atmosphere is desirable in the case of a laminate having a large size (for example, more than 200 mm) in order to obtain a stable peel strength over the entire surface. In contrast, pressing in a vacuum is preferable in the case of a laminate having a small size of about 200 mm or less. As the degree of vacuum, a degree of vacuum obtained by an ordinary oil-sealed rotary pump is sufficient, and about 10 Torr or less is sufficient. The pressure is preferably 1 MPa to 20 MPa, still more preferably 3 MPa to 10 MPa. The substrate may be destroyed when the pressure is high, and close contact may not be achieved at some portions when the pressure is low. The temperature is preferably 90°C to 300°C, still more preferably 100°C to 250°C. The film may be damaged when the temperature is high, and close contact force may be weak when the temperature is low.

fabrication of film with an electronic device (flexible electronic device)>

When the laminate is used, a flexible electronic device can be easily fabricated by using existing equipment and processes for electronic device manufacture. Specifically, a flexible electronic device can be fabricated by forming an electronic device on the highly heat-resistant transparent film of the laminate and peeling off the electronic device together with the highly heat-resistant transparent film from the laminate.

In the present specification, the electronic device refers to a wiring board which carries out electrical wiring and has a single-sided, double-sided, or multilayered structure, electronic circuits including active devices such as transistors and diodes and passive devices such as resistors, capacitors, and inductors, sensor elements which sense pressure, temperature, light, humidity and the like, biosensor elements, light emitting elements, image display elements such as

liquid crystal displays, electrophoresis displays, and self-luminous displays, wireless and wired communication elements, arithmetic elements, storage elements, MEMS elements, solar cells, thin film transistors, and the like.

The electronic device also includes an interposer function, which is an electrode that penetrates the polyimide in this wiring board. By roughly penetrating the electrode, the step of fabricating a through electrode after the inorganic substrate has been peeled off is largely omitted. A known method may be used to fabricate a through hole. For example, the highly heat-resistant transparent film is pierced with a UV nanolaser to form a through hole. Next, for example, there is a method in which the through hole is filled with a conductive metal by applying the conventional method used for through holes in double-sided printed wiring boards or via holes in multilayer printed wiring boards, and in addition, a wiring pattern of a metal is formed if necessary. The highly heat-resistant transparent film may be bonded to the inorganic substrate after a through electrode is formed in the film as described above. In some cases, a through electrode may be fabricated after the inorganic substrate and the highly heat-resistant transparent film are bonded together. It is also possible to penetrate the highly heat-resistant transparent film and metallize the penetrated portion, but it is also possible to metallize the penetrated portion in a state where a hole is formed on one side of the highly heat-resistant transparent film but does not penetrate the surface on the other side.

In the method for manufacturing a flexible electronic device in the present specification, a device is formed on the highly heat-resistant transparent film of the laminate fabricated by the above-described method and then the highly heat-resistant transparent film is peeled off from the inorganic substrate.

<Peeling off of highly heat-resistant transparent film with device from inorganic substrate>

The method for peeling off the highly heat-resistant transparent film with device from the inorganic substrate is not particularly limited, but a method in which the highly heat-resistant transparent film with device is stripped off from the end with tweezers and the like, a method in which a cut is made in the highly heat-resistant transparent film, a pressure sensitive adhesive tape is pasted to one side of the cut portion, and then the highly heat-resistant transparent film is stripped off from the tape portion, a method in which one side of the cut portion of the highly heat-resistant transparent film is vacuum-adsorbed and then the highly heat-resistant transparent film is stripped off from that portion, and the like can be employed. When the cut portion of the highly heat-resistant transparent film is bent with a small curvature at the time of peeling off, stress may be applied to the device at that portion and the device may be destroyed, and it is thus desirable to peel off the highly heat-resistant transparent film in a state of having a curvature as large as possible. For example, it is desirable to strip off the polymer film while winding the polymer film on a roll having a large curvature or to strip off the polymer film using a machine having a configuration in which the roll having a large curvature is located at the peeling portion.

As the method for making a cut in the highly heat-resistant transparent film, there are a method in which the highly heat-resistant transparent film is cut using a cutting tool such as a cutter, a method in which the highly heat-resistant transparent film is cut by scanning a laser and the laminate relative to each other, a method in which the highly heat-resistant transparent film is cut by scanning a water jet and the laminate relative to each other, a method in which the highly heat-resistant transparent film is cut while being cut a little to the glass layer using a dicing apparatus for semiconductor chips, and the like, but the method is not particularly limited. For example, when the above-described methods are employed, it is also possible to appropriately employ a method in which ultrasonic waves are superimposed on the cutting tool or a reciprocating motion, a vertical motion and the like are further added to improve the cutting performance.

It is also useful to stick another reinforcing base material to the portion to be peeled off in advance and peel off the polymer film together with the reinforcing base material. In a case where the flexible electronic device to be peeled off is the backplane of a display device, it is also possible to obtain a flexible display device by sticking the front plane of the display device in advance, integrating these on an inorganic substrate, and then peeling off these two at the same time.

EXAMPLES

Hereinafter, the present invention will be described in detail with reference to Examples, but the present invention is not limited to the following Examples as long as the gist of the present invention is not exceeded.

[Production Example 1 (Production of polyimide solution 1)]

While introducing nitrogen gas into a reaction vessel equipped with a nitrogen introducing tube, a Dean-Stark tube and a reflux tube, a thermometer, and a stirring bar, 19.86 parts by mass of 4,4'-diaminodiphenyl sulfone (4,4'-DDS), 4.97 parts by mass of 3,3'-diaminodiphenyl sulfone (3,3'-DDS), and 80 parts by mass of gamma-butyrolactone (GBL) ) were added. Subsequently, 31.02 parts by mass of 4,4'-oxydiphthalic dianhydride (ODPA), 24 parts by mass of

GBL, and 13 parts by mass of toluene were added at room temperature, then the temperature was raised to an internal temperature of 160°C, and the mixture was heated under reflux at 160°C for 1 hour for imidization. After the imidization was completed, the temperature was raised to 180°C, and the reaction was continuously conducted while extracting toluene. After the reaction for 12 hours, the oil bath was removed and the temperature was returned to room temperature, GBL was added so that the solid concentration was 20% by mass, and a polyimide solution 1 having a reduced viscosity of 0.70 dl/g was thus obtained (molar ratio of 4,4'-DDS/3,3'-DDS//ODPA = 0.80/0.20//1.00).

[Production Example 2 (Production of polyamic acid solution 2)]

The interior of a reaction vessel equipped with a nitrogen introducing tube, a reflux tube, and a stirring bar was purged with nitrogen, and then 32.02 parts by mass of 2,2'-ditrifluoromethyl-4,4'-diaminobiphenyl (TFMB) and 279.9 parts by mass of N,N-dimethylacetamide (DMAc) were added and completely dissolved. Subsequently, 9.81 parts by mass of 1,2,3,4-cyclobutanetetracarboxylic dianhydride (CBDA) and 15.51 parts by mass of 4,4'-oxydiphthalic dianhydride (ODPA) were each added dividedly in the solid form, and the mixture was stirred at room temperature for 24 hours. Thereafter, a polyamic acid solution 2 having a solid content of 17% by mass and a reduced viscosity of 3.60 dl/g was obtained (molar ratio of TFMB//CBDA/ODPA = 1.00//0.50/0.50) .

[Production Example 3 (Production of polyamic acid solution 3)]

The inside of a reaction vessel equipped with a nitrogen introducing tube, a reflux tube, and a stirring bar was purged with nitrogen, then 22.73 parts by mass of 4,4'-diaminobenzanilide (DABAN), 201.1 parts by mass of N,N-dimethylacetamide (DMAc), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.4% by mass of the total amount of polymer solids in the polyamic acid solution, and completely dissolved. Subsequently, 19.32 parts by mass of 1,2,3,4-cyclobutanetetracarboxylic dianhydride (CBDA) was added dividedly in the solid form, and the mixture was stirred at room temperature for 24 hours. Thereafter, 173.1 parts by mass of DMAc was added for dilution, thereby obtaining a polyamic acid solution 3 having NV (solid content) of 10% by mass and a reduced viscosity of 3.10 dl/g (molar ratio of DABAN/CBDA = 1.00/0.985).

[Production Example 4 (Production of polyamic acid solution 4)]

The inside of a reaction vessel equipped with a nitrogen introducing tube, a reflux tube, and a stirring bar was purged with nitrogen, then 32.02 parts by mass of 2,2'-ditrifluoromethyl-4,4'-diaminobiphenyl (TFMB), 252.1 parts by mass of N,N-dimethylacetamide (DMAc), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.4% by mass of the total amount of polymer solids in the polyamic acid solution, and completely dissolved. Subsequently, 19.61 parts by mass of 1,2,3,4-cyclobutanetetracarboxylic dianhydride (CBDA) was added dividedly in the solid form, and the mixture was stirred at room temperature for 24 hours. Thereafter, 165.7 parts by mass of DMAc was added for dilution, thereby obtaining a polyamic acid solution 4 having NV of 11% by mass and a reduced viscosity of 3.50 dl/g (molar ratio of TFMB/CBDA = 1.00/1.00) .

[Production Example 5]

After 205.8 parts by mass of 1,4-bis(4-amino-2-trifluoromethylphenoxy)benzene (p-6FAPB) and 1200 parts by mass of N,N-dimethylacetamide were charged and dissolved, 93.8 parts by mass of cyclobutanetetracarboxylic dianhydride (CBDA) was added dividedly in the solid form while cooling the reaction vessel, and the mixture was stirred at room temperature for 12 hours. Thereafter, 1.0 part by mass of 4-methylcyclohexane-1,2-dicarboxylic anhydride (MHHPA) was added, and the mixture was stirred for 4 hours and then diluted with 1000 parts by mass of N,N-methylacetamide to obtain a polyamic acid solution 5 having a reduced viscosity of 5.28 dl/g (molar ratio of p-6FAPB//CBDA/MHHPA = 0.480//0.478/0.0059).

[Production Example 6 (Production of polyamic acid solution 6)]

The inside of a reaction vessel equipped with a nitrogen introducing tube, a reflux tube, and a stirring bar was purged with nitrogen, then 22.0 parts by mass of 2,2'-bis(trifluoromethyl)benzidine (TFMB), 252.1 parts by mass of N,N-dimethylacetamide (DMAc), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.4% by mass of the total amount of polymer solids in the polyamic acid solution, and completely

dissolved. Subsequently, 22.0 parts by mass of 3,3',4,4'-biphenyltetracarboxylic dianhydride (BPDA) was added dividedly in the solid form, and the mixture was stirred at room temperature for 24 hours. Thereafter, 165.7 parts by mass of DMAc was added for dilution, thereby obtaining a polyamic acid solution 6 having a solid content (NV) of 11% by mass and a reduced viscosity of 3.5 dl/g (molar ratio of TFMB/BPDA = 0.075/0.069).

[Production Example 7 (Production of polyamic acid solution 7)]

The inside of a reaction vessel equipped with a nitrogen introducing tube, a reflux tube, and a stirring bar was purged with nitrogen, then 22.00 parts by mass of 2,2'-bis(trifluoromethyl)benzidine (TFMB), 252.1 parts by mass of N,N-dimethylacetamide (DMAc), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.4% by mass of the total amount of polymer solids in the polyamic acid solution, and completely dissolved. Subsequently, 11.01 parts by mass of 3,3',4,4'-biphenyltetracarboxylic dianhydride (BPDA) and 10.98 parts by mass of 4,4'-oxydiphthalic dianhydride (ODPA) were added dividedly in the solid form, and the mixture was stirred at room temperature for 24 hours. Thereafter, 165.7 parts by mass of DMAc was added for dilution, thereby obtaining a polyamic acid solution 7 having a solid content (NV) of 11% by mass and a reduced viscosity of 3.5 dl/g (molar ratio of TFMB/ODPA/BPDA = 0.068/0.035/0.037).

[Production Example 8 (Production of polyamic acid solution 8)]

The interior of a reaction vessel equipped with a nitrogen introducing tube, a reflux tube, and a stirring bar was purged with nitrogen, and then 33.36 parts by mass of 2,2'-ditrifluoromethyl-4,4'-diaminobiphenyl (TFMB) and 336.31 parts by mass of N-methyl-2-pyrrolidone (NMP) were added and completely dissolved. Subsequently, 9.81 parts by mass of 1,2,3,4-cyclobutanetetracarboxylic dianhydride (CBDA), 11.34 parts by mass of 3,3',4,4'-biphenyltetracarboxylic dianhydride (BPDA), 4.85 parts by mass of 4,4'-oxydiphthalic dianhydride (ODPA) were each added dividedly in the solid form, and the mixture was stirred at room temperature for 24 hours. Thereafter, a polyamic acid solution 8 having a solid content of 15% by mass and a reduced viscosity of 3.50 dl/g was obtained (molar ratio of TFMB//CBDA/BPDA/ODPA = 1.00//0.48/0.37/0.15) .

[Production Example 9 (Production of polyamic acid solution 9)]

The inside of a reaction vessel equipped with a nitrogen introducing tube, a reflux tube, and a stirring bar was purged with nitrogen, then 33.36 parts by mass of 2,2'-bis(trifluoromethyl)benzidine (TFMB), 270.37 parts by mass of N-methyl-2-pyrrolidone (NMP), and a dispersion obtained by dispersing colloidal silica in dimethylacetamide ("SNOWTEX (registered trademark) DMAC-ST" manufactured by Nissan Chemical Corporation) were added so that silica (lubricant) was 0.14% by mass of the total amount of polymer solids in the polyamic acid solution, and completely dissolved. Subsequently, 9.81 parts by mass of 1,2,3,4-cyclobutanetetracarboxylic dianhydride (CBDA), 11.34 parts by mass of 3,3',4,4'-biphenyltetracarboxylic dianhydride (BPDA), 4.85 parts by mass of 4,4'-oxydiphthalic dianhydride (ODPA) were added dividedly in the solid form, and the mixture was stirred at room temperature for 24 hours. Thereafter, 165.7 parts by mass of DMAc was added for dilution, thereby obtaining a polyamic acid solution 9 having a solid content of 18% by mass and a reduced viscosity of 2.7 dl/g (molar ratio of TFMB//CBDA/BPDA/ODPA = 1.00//0.48/0.37/0.15).

[Production Example 10 (Production of polyamic acid solution 10)]

The inside of a reaction vessel equipped with a nitrogen introducing tube, a reflux tube, and a stirring bar was purged with nitrogen, then 33.36 parts by mass of 2,2'-ditrifluoromethyl-4,4'-diaminobiphenyl (TFMB), 336.31 parts by mass of N-methyl-2-pyrrolidone (NMP), and a dispersion obtained by dispersing colloidal silica as a lubricant in dimethylacetamide ("SNOWTEX (registered trademark) DMAC-ST-ZL" manufactured by Nissan Chemical Corporation) were added so that silica (lubricant) was 0.3% by mass of the total amount of polymer solids in the polyamic acid solution, and completely dissolved. Subsequently, 9.81 parts by mass of 1,2,3,4-cyclobutanetetracarboxylic dianhydride (CBDA), 11.34 parts by mass of 3,3',4,4'-biphenyltetracarboxylic dianhydride (BPDA), and 4.85 parts by mass of 4,4'-oxydiphthalic dianhydride (ODPA) were each added dividedly in the solid form, and the mixture was stirred at room temperature for 24 hours. Thereafter, a polyamic acid solution 10 having a solid content of 15% by mass and a reduced viscosity of 3.50 dl/g was obtained (molar ratio of TFMB//CBDA/BPDA/ODPA = 1.00//0.48/0.37/0.15).

[Fabrication Example 1 (Fabrication of polyimide films A, A2, and A3)]

The polyamic acid solution 3 obtained in Production Example 3 was adjusted and applied onto the lubricant-free surface of polyethylene terephthalate film A4100 (manufactured by TOYOBO CO., LTD.) using a comma coater so that the final film thickness was 3 um. The polyethylene terephthalate film A4100 was allowed to pass through a hot air furnace, wound up, and dried at 100°C for 10 minutes at this time. This was wound up and then set again on the comma coater side, and subsequently the polyimide solution 1 obtained in Production Example 1 was applied onto the dried product of the polyamic acid solution 3 so that the final film thickness was 15 μm. This was dried at 100°C for 10 minutes. The polyamic acid film that gained self-supporting properties after drying was peeled off from the support, allowed to pass through a pin tenter with a pin sheet having pins disposed, and gripped by inserting the film ends into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both ends of the film were cut off using a slitter, and the film was wound into a roll shape, thereby obtaining a polyimide film A1 having a width of 450 mm by 500 m.

[Fabrication Example 2]

The polyamic acid solution 3 obtained in Production Example 3 was applied onto the lubricant-free surface of polyethylene terephthalate film A4100 (manufactured by TOYOBO CO., LTD.) using a comma coater so that the final film thickness was 3 um. Subsequently, the polyimide solution 1 obtained in Production Example 1 was applied onto the polyamic acid solution 3 using a die coater so that the final film thickness was 15 um. This was dried at 110°C for 10 minutes. The polyamic acid film that gained self-supporting properties after drying was peeled off from the A4100 film that had served as a support, allowed to pass through a pin tenter with a pin sheet having pins disposed, and gripped by inserting the film ends into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both ends of the film were cut off using a slitter, and the film was wound into a roll shape, thereby obtaining a polyimide film A2 having a width of 450 mm by 500 m.

[Fabrication Example 3]

The start end of a part of the polyimide film A2 was temporarily fixed on the lubricant-free surface of polyethylene terephthalate film A4100 (manufactured by TOYOBO CO., LTD.) with a polyimide pressure sensitive adhesive tape. The polyamic acid solution 3 obtained in Production Example 3 was applied thereonto using a die coater so that the final film thickness was 3 um. At this time, the polyamic acid solution 3 side of the polyimide film A2 was in contact with the polyethylene terephthalate film A4100, and coating was performed on the polyimide solution 1 side. This polyimide film A2 was dried at 90°C for 10 minutes. After drying, the polyimide tape was peeled off and separated from the polyethylene terephthalate film A4100, the film was allowed to pass through a pin tenter with a pin sheet having pins disposed, and gripped by inserting the film ends into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both ends of the film were cut off using a slitter, and the film was wound into a roll shape, thereby obtaining a polyimide film A3 having a width of 400 mm by 200 m.

[Fabrication Example 4 (Fabrication of polyimide film B)]

A polyimide film B was obtained by performing the same operation as that for the polyimide film A1 of Fabrication Example 1 except that the polyamic acid solution 3 obtained in Production Example 3 was changed to the polyamic acid solution 4 obtained in Production Example 4.

[Fabrication Example 5 (Fabrication of polyimide film C)]

A polyimide film C was obtained by performing the same operation as that at the time of the fabrication of the polyimide film A1 of Fabrication Example 1 except that the polyimide solution 1 obtained in Production Example 1 was changed to the polyamic acid solution 2 obtained in Production Example 2 and was adjusted so that the final film thickness was 1 um.

[Fabrication Example 6 (Fabrication of polyimide film D)]

The polyamic acid solution 3 obtained in Production Example 3 was adjusted and applied onto the lubricant-free surface of polyethylene terephthalate film A4100 (manufactured by TOYOBO CO., LTD.) using a comma coater so that the final film thickness was 3 μm. This was dried at 90°C to 110°C for 10 minutes. This was wound up and then set again on the comma coater side, and subsequently the polyimide solution 1 obtained in Production Example 1 was applied onto the dried product of the polyamic acid solution 3 so that the final film thickness was 15 um. This was dried at 90°C to 110°C for 10 minutes. This was wound up and then set again on the comma coater side, and subsequently the polyimide solution 3 obtained in Production Example 3 was applied onto the dried product of the polyamic acid solution 1 so that the final film thickness was 3 μm. This was dried at 90°C to 110°C for 10 minutes. The polyamic acid film that gained self-supporting properties after drying was peeled off from the support, allowed to pass through a pin tenter with a pin sheet having pins disposed, and gripped by inserting the film ends into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both ends of the film were cut off using a slitter, and the film was wound into a roll shape, thereby obtaining a polyimide film D1 having a width of 450 mm by 500 m.

[Fabrication Example 7 (Fabrication of polyimide film D2)]

A polyimide film D2 was obtained by performing the same operation as that in Fabrication Example 6 except that the coating thickness was adjusted so that the final film thickness of the polyimide solution 1 was 19 μm.

[Fabrication Example 8 (Fabrication of polyimide film E)]

The polyimide solution 1 obtained in Production Example 1 was applied onto a glass substrate using a casting applicator, and heated from room temperature to 300°C in a nitrogen ambience, and kept at 300°C for 1 hour for thermal imidization, thereby obtaining a polyimide film/glass laminate. Subsequently, the obtained laminate was immersed in water, and then peeling off and drying were performed, thereby obtaining a polyimide film E having a film thickness of 15 um.

[Fabrication Example 9 (Fabrication of polyimide film F)]

A polyimide film F was obtained by performing the same operation as that in Fabrication Example 8 except that the polyimide solution 1 obtained in Production Example 1 was changed to the polyamic acid solution 2 obtained in Production Example 2.

[Fabrication Example 10 (Fabrication of polyimide film G)]

A polyimide film G was obtained by performing the same operation as that in Fabrication Example 1 except that the polyamic acid solution 3 was changed to the polyamic acid solution 2.

[Fabrication Example 11 (Fabrication of polyimide film H)]

A polyimide film H was obtained by performing the same operation as that in Fabrication Example 8 except that the polyimide solution 1 obtained in Production Example 1 was changed to the polyamic acid solution 3.

[Fabrication Example 12 (Fabrication of polyimide film I)]

A polyimide film I was obtained by performing the same operation as that in Fabrication Example 8 except that the polyimide solution 1 obtained in Production Example 1 was changed to the polyamic acid solution 4.

[Fabrication Example 13 (Fabrication of polyimide film J)]

A polyimide film J was obtained by performing the same operation as that in Fabrication Example 8 except that the polyimide solution 1 obtained in Production Example 1 was changed to the polyamic acid solution 2 and the design film thickness was changed to 25 μm.

[Fabrication Example 14 (Fabrication of polyimide film K)]

A polyimide film K was obtained by performing the same operation as that in Fabrication Example 8 except

that the polyimide solution 1 obtained in Production Example 1 was changed to the polyamic acid solution 5.

[Fabrication Example 15 (Fabrication of polyimide film L)]

A polyimide film L was obtained by performing the same operation as that for the polyimide film A in Fabrication Example 1 except that the polyimide solution 1 was changed to the polyamic acid solution 5.

[Fabrication Example 16 (Fabrication of polyimide film M)]

The polyamic acid solution 6 obtained in Production Example 6 was adjusted and applied onto the lubricant-free surface of polyethylene terephthalate film A4100 (manufactured by TOYOBO CO., LTD.) using a comma coater so that the final film thickness was 0.5 μm. The polyethylene terephthalate film A4100 was allowed to pass through a hot air furnace, wound up, and dried at 100°C for 10 minutes at this time. This was wound up and then set again on the comma coater side, and subsequently the polyimide solution 1 obtained in Production Example 1 was applied onto the dried product of the polyamic acid solution 6 so that the final film thickness was 15 μm. This was dried at 100°C for 10 minutes. The polyamic acid film that gained self-supporting properties after drying was peeled off from the support, allowed to pass through a pin tenter with a pin sheet having pins disposed, and gripped by inserting the film ends into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both ends of the film were cut off using a slitter, and the film was wound into a roll shape, thereby obtaining a polyimide film M having a width of 450 mm by 500 m.

[Fabrication Example 17 (Fabrication of polyimide film N)]

A polyimide film N was obtained in the same manner as in Fabrication Example 16 except that the polyamic acid solution 6 was changed to the polyamic acid solution 7.

[Fabrication Example 18 (Fabrication of polyimide film O)]

The polyimide solution 1 obtained in Production Example 1 was applied onto the lubricant-free surface of polyethylene terephthalate film A4100 (manufactured by TOYOBO CO., LTD.) using a comma coater so that the final film thickness was 15 μm. Subsequently, the polyimide solution 3 obtained in Production Example 3 was applied onto the polyimide solution 1 using a die coater so that the final film thickness was 0.5 um. This was dried at 110°C for 10 minutes. The polyamic acid film that gained self-supporting properties after drying was peeled off from the A4100 film that had served as a support, allowed to pass through a pin tenter with a pin sheet having pins disposed, and gripped by inserting the film ends into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both ends of the film were cut off using a slitter, and the film was wound into a roll shape, thereby obtaining a polyimide film O having a width of 450 mm by 500 m.

[Fabrication Example 19 (Fabrication of polyimide film P)]

A polyimide film P was obtained in the same manner as in Fabrication Example 16 except that the polyamic acid solution 6 was changed to the polyamic acid solution 3, the polyimide solution 1 was changed to the polyamic acid solution 8, and the heating conditions for the imidization reaction were changed to heating at 200°C for 3 minutes, at 250°C for 3 minutes, at 300°C for 3 minutes, and at 350°C for 3 minutes.

[Fabrication Example 20 (Fabrication of polyimide film Q)]

A polyimide film Q was obtained in the same manner as in Fabrication Example 16 except that the polyamic acid solution 6 was changed to the polyamic acid solution 3, the polyimide solution 1 was changed to the polyamic acid solution 9, and the heating conditions for the imidization reaction were changed to heating at 200°C for 3 minutes, at 250°C for 3 minutes, at 300°C for 3 minutes, and at 350°C for 3 minutes.

[Fabrication Example 21 (Fabrication of polyimide film R)]

A polyimide film R was obtained in the same manner as in Fabrication Example 16 except that the polyimide solution 1 was changed to the polyamic acid solution 9.

[Fabrication Example 22 (Fabrication of polyimide film S)]

A polyimide film S was obtained in the same manner as in Fabrication Example 8 except that the polyimide solution 1 was changed to the polyamic acid solution 8.

[Fabrication Example 23 (Fabrication of polyimide film T)]

A polyimide film T was obtained in the same manner as in Fabrication Example 8 except that the polyimide solution 1 was changed to the polyamic acid solution 9.

[Fabrication Example 24 (Fabrication of polyimide film U)]

A polyimide film U was obtained in the same manner as in Fabrication Example 16 except that the polyamic acid solution 6 was changed to the polyamic acid solution 10, the polyimide solution 1 was changed to the polyamic acid solution 8, and the heating conditions for the imidization reaction were changed to heating at 200°C for 3 minutes, at 250°C for 3 minutes, at 300°C for 3 minutes, and at 350°C for 3 minutes.

<Measurement of thickness of polyimide film>

The thickness of the polyimide films A to U was measured using a micrometer (Millitron 1245D manufactured by Feinpruf GmbH). The results are presented in Tables 1 and 2.

<Tensile elasticity, tensile breaking strength, and tensile breaking elongation of polyimide film>

The polyimide films A to U were cut into a strip shape of 100 mm × 10 mm in the machine direction (MD direction) and the transverse direction (TD direction) respectively to be used as test pieces. Tensile elasticity, tensile breaking strength and tensile breaking elongation of the test piece in the MD direction and the TD direction were measured respectively at tensile speed of 50 mm/minute and a distance between chucks of 40 mm by a tensile tester (Autograph (R), Trade Name of AG-5000A manufactured by Shimadzu Corporation). The results are presented in Tables 1 and 2.

<Coefficient of linear thermal expansion (CTE) of polyimide film>

The expansion/contraction rate of the polyimide films A to U in the machine direction (MD direction) and the transverse direction (TD direction) were measured under the following conditions, and expansion/contraction rate/temperature was measured at intervals of 15°C, such as 30°C to 45°C and 45°C to 60°C, this measurement was performed up to 300°C, and the average value of all measured values was calculated as CTE. The results are presented in Tables 1 and 2.

Instrument name: TMA4000S manufactured by MAC Science Corporation

Length of sample: 20 mm
Width of sample: 2 mm
Start temperature in temperature increase: 25°C
End temperature in temperature increase: 300°C
Rate of temperature increase: 5°C/min
Ambience: Argon

<Thickness direction retardation (Rth) of polyimide film>

The refractive index nx in the X-axis direction, the refractive index ny in the Y-axis direction, and the refractive index nz in the Z-axis direction of the polyimide films A to U were measured with light having a wavelength of 550 nm at room temperature (20°C to 25°C) using an optical material inspection system (Model RETS-100) manufactured by Otsuka Electronics Co., Ltd.. The optical axis was detected and the phase advance and phase delay was corrected, and then the retardation measurement method was measured by the rotating analyzer method. Here, the X-axis and

the Y-axis indicate the refractive index (nx) in the direction having the largest refractive index in the plane direction of the film and the refractive index (ny) in the direction perpendicular to the Nx direction in the plane direction of the film. Then, Rth was calculated from the refractive index nx in the X-axis direction, the refractive index ny in the Y-axis direction, the refractive index nz in the Z-axis direction, and the film thickness (d) based on the following equation. The results are presented in Tables 1 and 2.

$$Rth\ (nm) = |[nz - (nx + ny)/2] \times d|$$

<Heat shrinkage of polyimide film>

The temperature was raised to 300°C and then lowered to 80°C when the coefficient of linear thermal expansion (CTE) of the polyimide film was measured, and the percentage of the ratio of the length at 100°C during the initial temperature increase to the length at 100°C during the temperature decrease was calculated as the heat shrinkage rate. The results are presented in Tables 1 and 2.

<Measurement of layer intermingling>

For layer intermingling, a diagonally cut surface of a polyimide film is prepared using Model SAICAS DN-20S (DAIPLA WINTES CO., LTD.). Next, this diagonally cut surface was subjected to the measurement by a microscopic ATR method using a germanium crystal (incident angle: 30°) and microscopic IRCary 620 FTIR (Agilent Technologies, Inc.). It was thus confirmed that the intermingled layer of the films other than the film A2 was 0.8 um (800 nm) or less. The intermingled layer of the film A2 was 1.5 μm.

[Table 1]

| Fabrication Example | | | 1 | 2 | 3 | 4 | 5 | 6 | 7 | 8 | 9 | 10 | 11 | 12 |
|---|---|---|---|---|---|---|---|---|---|---|---|---|---|---|
| Film No. | | | A1 | A2 | A3 | B | C | D1 | D2 | E | F | G | H | I |
| Polyamic acid used | | | 1 | 1 | 1 | 1 | 2 | 1 | 1 | 1 | 2 | 1 | 3 | 4 |
| | | | 3 | 3 | 3 | 4 | 3 | 3 | 3 | - | - | 2 | - | - |
| Thickness | | μm | 17.7 | 18.2 | 21.1 | 16.1 | 15.6 | 21.5 | 16.2 | 23.1 | 15.5 | 18.7 | 16.8 | 13 |
| Tensile breaking strength | MD | MPa | 141 | 143 | 147 | 142 | 144 | 146 | 141 | 136 | 146 | 113 | 128 | 123 |
| | TD | | 141 | 145 | 149 | 145 | 136 | 132 | 143 | 137 | 143 | 123 | 118 | 127 |
| | Average | | 141 | 144 | 148 | 144 | 140 | 139 | 142 | 137 | 145 | 118 | 123 | 125 |
| Tensile elasticity | MD | GPa | 3.5 | 3.4 | 3.4 | 3.5 | 3.4 | 3.4 | 3.6 | 3.2 | 3.4 | 3.3 | 4.3 | 4.4 |
| | TD | | 3.3 | 3.6 | 3.7 | 3.4 | 3.5 | 3.5 | 3.5 | 3.3 | 3.5 | 2.9 | 4.1 | 4.3 |
| | Average | | 3.4 | 3.5 | 3.6 | 3.4 | 3.5 | 3.5 | 3.5 | 3.3 | 3.5 | 3.1 | 4.2 | 4.4 |
| Tensile breaking elongation | MD | % | 12.3 | 9.0 | 10.1 | 9.7 | 14.5 | 10.5 | 11.0 | 13.7 | 19.5 | 9.1 | 5.2 | 8.2 |
| | TD | | 10.8 | 13.3 | 10.5 | 7.4 | 9.5 | 11.4 | 9.7 | 15.1 | 16.0 | 5.6 | 6.3 | 7.2 |
| | Average | | 11.6 | 11.2 | 10.3 | 8.6 | 12.0 | 11.0 | 10.4 | 14.4 | 17.8 | 7.4 | 5.8 | 7.7 |
| Coefficient of linear thermal expansion (CTE) | MD | ppm/K | 43.5 | 45.3 | 44.5 | 43.4 | 34.3 | 38.4 | 35.2 | 48.8 | 38.4 | 38.2 | 16.7 | 19.4 |
| | TD | | 44.5 | 46.3 | 45.1 | 44.7 | 34.1 | 42.0 | 36.0 | 48.5 | 39.5 | 39.2 | 17.6 | 15.8 |
| | Average | | 44.0 | 45.8 | 44.8 | 44.1 | 34.2 | 40.2 | 35.6 | 48.7 | 39.0 | 38.7 | 17.2 | 17.6 |
| Thickness direction retardation (Rth) | | nm | 247 | 249 | 255 | 179 | 278 | 256 | 244 | 52 | 78 | 50 | 1200 | 650 |
| Intermingling of layers | | nm | 520 | 1530 | 420 | 670 | 650 | 590 | 710 | - | - | 630 | - | - |

[Table 2]

| Fabrication Example | | | 13 | 14 | 15 | 16 | 17 | 18 | 19 | 20 | 21 | 22 | 23 | 24 |
|---|---|---|---|---|---|---|---|---|---|---|---|---|---|---|
| Film No. | | | J | K | L | M | N | O | P | Q | R | S | T | U |
| Polyamic acid used | | | 2 | 5 | 5 | 1 | 1 | 3 | 8 | 9 | 9 | 8 | 9 | 8 |
| | | | - | - | 3 | 6 | 7 | 1 | 3 | 3 | 6 | - | - | 10 |
| Thickness | | μm | 24.8 | 14.7 | 17.8 | 15.2 | 15.7 | 18.1 | 16.1 | 17.3 | 17.8 | 15.1 | 15.7 | 17.6 |
| Tensile breaking strength | MD | MPa | 114 | 168 | 146 | 144 | 142 | 142 | 151 | 175 | 215 | 155 | 221 | 156 |
| | TD | | 114 | 165 | 147 | 143 | 144 | 141 | 153 | 176 | 213 | 151 | 219 | 160 |
| | Average | | 114 | 167 | 147 | 144 | 143 | 142 | 152 | 177 | 214 | 153 | 220 | 158 |
| Tensile elasticity | MD | GPa | 3.7 | 3.2 | 3.3 | 4.5 | 4.1 | 3.4 | 4.6 | 6.1 | 5.7 | 4.4 | 6.2 | 4.1 |
| | TD | | 2.6 | 3.3 | 3.5 | 4.8 | 4.5 | 3.3 | 4.8 | 6.4 | 6.0 | 4.2 | 6.0 | 4.3 |
| | Average | | 3.2 | 3.3 | 3.4 | 4.7 | 4.3 | 3.4 | 4.7 | 6.3 | 5.9 | 4.3 | 6.1 | 4.2 |
| Tensile breaking elongation | MD | % | 5.7 | 97.0 | 10.0 | 12.3 | 13.1 | 12.4 | 12.5 | 4.2 | 5.5 | 12.8 | 5.8 | 13.9 |
| | TD | | 4.9 | 96.0 | 13.0 | 12.5 | 11.1 | 12.1 | 11.3 | 4.1 | 5.4 | 12.5 | 5.7 | 12.9 |
| | Average | | 5.3 | 96.5 | 11.5 | 12.4 | 12.1 | 12.3 | 11.9 | 4.1 | 5.5 | 12.7 | 5.8 | 13.4 |
| Coefficient of linear thermal expansion (CTE) | MD | ppm/K | 37.4 | 57.3 | 52.4 | 38.5 | 38.4 | 43.2 | 37.3 | 28.5 | 30.1 | 37.9 | 28.8 | 39.1 |
| | TD | | 38.0 | 58.2 | 51.7 | 38.3 | 38.3 | 44.5 | 35.1 | 27.9 | 29.7 | 37.1 | 28.6 | 37.9 |
| | Average | | 37.7 | 57.8 | 52.1 | 38.4 | 38.4 | 43.9 | 36.7 | 28.2 | 29.9 | 37.5 | 28.7 | 38.5 |
| Thickness direction retardation (Rth) | | nm | 125 | 23 | 488 | 62 | 59 | 1258 | 334 | 191 | 185 | 289 | 145 | 252 |
| Intermingling of layers | | nm | - | - | 590 | 230 | 180 | 180 | 250 | 180 | 240 | - | - | 250 |

(Example 1)

The method for coating a glass substrate with a silane coupling agent was carried out using an experimental apparatus illustrated in Fig. 1. Fig. 1 is a schematic diagram of an experimental apparatus for coating a glass substrate with a silane coupling agent. A glass substrate 1 (0.7 mm thick OA11G glass cut into a size of 100 mm × 100 mm (manufactured by NEG Co., Ltd.)) was used. The glass substrate 1 used was washed with pure water, dried, and then irradiated using a UV/$O_3$ irradiator (SKR1102N-03 manufactured by LANTECHNICAL SERVICE CO., LTD.) for 1 minute for dry cleaning. Into a chemical tank having a capacity of 1 L, 150 g of 3-aminopropyltrimethoxysilane (silane coupling agent, Shin-Etsu Chemical KBM903) was put, and the outer water bath of this chemical tank was warmed to 43°C. The vapor that came out was then sent to the chamber together with clean dry air. The gas flow rate was set to 25 L/min and the substrate temperature was set to 42°C. The temperature of clean dry air was 23°C and the humidity thereof was 1.2% RH. Since the exhaust is connected to the exhaust port having a negative pressure, it is confirmed that the chamber has a negative pressure of about 10 Pa by a differential pressure gauge. The thickness of the obtained silane coupling agent layer is as presented in Table 3.

Next, the polyimide film A1 (size: 70 mm × 70 mm) was bonded on the silane coupling agent layer to obtain a laminate. At this time, the bonded surface is a polyimide surface formed from the polyamic acid solution 3. A laminator manufactured by MCK CO., LTD. was used for bonding, and the bonding conditions were set to compressed air pressure: 0.6 MPa, temperature: 22°C, humidity: 55% RH, and lamination speed: 50 mm/sec. The measurement results of this laminate are as presented in Table 3.

(Example 2)

A laminate was obtained in the same manner as in Example 1 except that the highly heat-resistant transparent film used was changed from film A1 to film B. At this time, the bonded surface is a polyimide surface formed from the polyamic acid solution 4. The measurement results of this laminate are as presented in Table 3.

(Example 3)

A laminate was obtained in the same manner as in Example 1 except that the highly heat-resistant transparent film used was changed from film A1 to film C. At this time, the bonded surface is a polyimide surface formed from the polyamic acid solution 3. The measurement results of this laminate are as presented in Table 3.

(Example 4)

A laminate was obtained in the same manner as in Example 1 except that the highly heat-resistant transparent film used was changed from film A1 to film D1. At this time, the bonded surface is a polyimide surface formed from the polyamic acid solution 3. The measurement results of this laminate are as presented in Table 3.

(Example 5)

A laminate was obtained in the same manner as in Example 1 except that the highly heat-resistant transparent film used was changed from film A1 to film D2. At this time, the bonded surface is a polyimide surface formed from the polyamic acid solution 3. The measurement results of this laminate are as presented in Table 3.

(Example 6)

A laminate was obtained in the same manner as in Example 1 except that the method for applying the silane coupling agent was changed as follows. In this coating method, a glass substrate 1 (0.7 mm thick OA11G glass cut into a size of 100 mm × 100 mm (manufactured by NEG Co., Ltd.)) was installed on a spin coater (MSC-500S manufactured by JAPAN CREATE Co., Ltd.). Isopropyl alcohol (IPA) was dropped onto the glass substrate 1, then spread over the entire surface of the glass substrate by rotating the spin coater at 500 rpm, and dried. Then 1% IPA solution of silane coupling agent 3-aminopropyltrimethoxysilane (Shin-Etsu Chemical KBM903) was dropped onto the glass, and shaking off of the silane coupling agent diluted solution and drying were performed by rotating the spin coater at 2000 rpm. The rotation was stopped 30 seconds after the dropping. A silane coupling agent layer was thus formed on a glass substrate. The measurement results of this laminate are as presented in Table 3.

(Example 7)

A laminate was obtained in the same manner as in Example 6 except that the highly heat-resistant transparent film used was changed from film D2 to film A1. At this time, the bonded surface is a polyimide surface formed from the polyamic acid solution 3. The measurement results of this laminate are as presented in Table 4.

(Example 8)

A laminate was obtained in the same manner as in Example 1 except that for SCA application, the glass substrate 1 was placed in the apparatus illustrated in Fig. 1 in Example 1, but the film A1 fixed to the glass substrate 1 with tape was placed in the apparatus illustrated in Fig. 1 and SCA was applied to the film A1, then the SCA-coated film A1 was peeled off from the glass substrate 1, and the SCA-coated surface was brought into contact with the glass side of the glass substrate 1 different from the glass used at this time and bonded. The glass substrate was washed with pure water, dried, and then irradiated using a UV/$O_3$ irradiator (SKR1102N-03 manufactured by LANTECHNICAL SERVICE CO., LTD.) for 1 minute for dry cleaning. At this time, the bonded surface is a polyimide surface formed from the polyamic acid solution 3. The measurement results of this laminate are as presented in Table 4.

(Example 9)

A laminate was obtained in the same manner as in Example 3 except that the highly heat-resistant transparent film used was changed from film A1 to film A3 as well as the SCA application time using the apparatus illustrated in Fig. 1 was changed to 5 minutes. At this time, the bonded surface is a polyimide surface formed from the polyamic acid solution 3 applied last. The measurement results of this laminate are as presented in Table 4.

(Example 10)

A laminate was obtained in the same manner as in Example 5 except that the highly heat-resistant transparent film used was changed from film D2 to film A3. At this time, the bonded surface is a polyimide surface formed from the polyamic acid solution 3 applied last. The evaluation of the obtained laminate is as presented in Table 4.

(Example 11)

A laminate was obtained in the same manner as in Example 5 except that the highly heat-resistant transparent film used was changed from film D2 to film A2. The evaluation of the obtained laminate is as presented in Table 4.

(Example 12)

The substrate was changed from glass substrate 1 to glass substrate 2 (730 × 920 mm). A laminate was obtained in the same manner as in Example 5 except that the application of silane coupling agent was changed and the laminator was changed to a large apparatus for this reason. At this time, the bonded surface is a polyimide surface formed from the polyamic acid solution 3. The measurement results of this laminate are as presented in Table 4.

(Example 13)

A laminate was obtained in the same manner as in Example 3 except that the substrate was changed from glass substrate 1 to a silicon wafer (dummy grade 8-inch wafer) divided into four portions. The measurement results of this laminate are as presented in Table 4.

(Example 14)

The same procedure as in Example 1 was carried out except that the heat-resistant transparent film used was changed to film M. The surface to be bonded to the glass substrate was a surface formed using the polyamide solution 6. The measurement results of this laminate are as presented in Table 5.

(Example 15)

The same procedure as in Example 1 was carried out except that the heat-resistant transparent film used was changed to film N. The surface to be bonded to the glass substrate was a surface formed using the polyamide solution

7. The measurement results of this laminate are as presented in Table 5.

(Example 16)

The same procedure as in Example 1 was carried out except that the heat-resistant transparent film used was changed to film O. The surface to be bonded to the glass substrate was a surface formed using the polyamide solution 3. The measurement results of this laminate are as presented in Table 5.

(Example 17)

The same procedure as in Example 1 was carried out except that the heat-resistant transparent film used was changed to film P. The surface to be bonded to the glass substrate was a surface formed using the polyamide solution 3. The measurement results of this laminate are as presented in Table 5.

(Example 18)

The same procedure as in Example 1 was carried out except that the heat-resistant transparent film used was changed to film Q. The surface to be bonded to the glass substrate was a surface formed using the polyamide solution 3. The measurement results of this laminate are as presented in Table 5.

(Example 19)

The same procedure as in Example 1 was carried out except that the heat-resistant transparent film used was changed to film R. The surface to be bonded to the glass substrate was a surface formed using the polyamide solution 6. The measurement results of this laminate are as presented in Table 5.

(Example 20)

The same procedure as in Example 1 was carried out except that the heat-resistant transparent film used was changed to film U. The surface to be bonded to the glass substrate was a surface formed using the polyamide solution 10. The measurement results of this laminate are as presented in Table 5.

(Circuit Fabrication Example 1)

Each film obtained above was slit into a roll size having a width of 50 cm and subjected to plasma treatment under the following conditions using a continuous vacuum apparatus having an unwinding/winding portion from the roll.

The conditions for plasma treatment were in oxygen gas, a frequency of 13.56 MHz, an output of 150 W, and a gas pressure of 0.7 Pa, and the temperature at the time of treatment was 25°C and the treatment time was 5 minutes. Subsequently, a nickel-chromium alloy film (underlayer) having a thickness of 120 Å was formed at a rate of 10 Å/sec by the RF sputtering method in an argon ambience using a nickel-chromium (15% by mass) alloy target under the conditions of a frequency of 13.56 MHz, an output of 500 W, and a gas pressure of 0.7 Pa. Copper was then deposited at a rate of 150 Å/sec to form a copper thin film having a thickness of 0.25 μm, and the film was wound up in a vacuum. A one-side metallized film was thus obtained. A hole that did not penetrate was made on the metal layer side of this film using a nanolaser having a wavelength of 355 nm by adjusting the time.

A thickening copper plated layer (thickening layer) having a thickness of 3 um was formed on the obtained film with one-side metal thin film containing a non-through hole using a roll-to-roll vertical continuous electroplating apparatus and a copper sulfate plating bath, thereby obtaining the intended metallized polyimide film. The obtained metallized polyimide film was slit to have a width of 48 mm, a sprocket hole was formed, then electroless plating was performed, and then double-sided through-hole plating was performed so that the maximum thickness was 6 um. Thereafter, a photoresist: FR-200 manufactured by Chypre Co., Ltd. was applied and dried, followed by close exposure with a glass photomask, and further development was performed with a 1.2% by mass KOH aqueous solution. Next, etching was performed with an etching line of cupric chloride containing HCl and hydrogen peroxide at 40°C and a spray pressure of 2 $kgf/cm^2$, thereby fabricating a heat-resistant transparent film with electrode for film connection. After this, a laminate with an inorganic substrate was fabricated in the same manner as in Examples.

(Comparative Example 1)

A laminate was obtained in the same manner as in Example 1 except that the highly heat-resistant transparent

film used was changed from film A1 to film E. At this time, the bonded surface is a polyimide surface that is in contact with the support when the polyamic acid solution is applied. The evaluation of the obtained laminate is as presented in Table 6.

(Comparative Example 2)

A laminate was obtained in the same manner as in Example 7 except that the highly heat-resistant transparent film used was changed from film A1 to film E. At this time, the bonded surface is a polyimide surface that is in contact with the support when the polyamic acid solution is applied. The evaluation of the obtained laminate is as presented in Table 6.

(Comparative Example 3)

A laminate was obtained in the same manner as in Example 1 except that the highly heat-resistant transparent film used was changed from film A1 to film F. At this time, the bonded surface is a polyimide surface that is in contact with the support when the polyamic acid solution is applied. The evaluation of the obtained laminate is as presented in Table 6.

(Comparative Example 4)

A laminate was obtained in the same manner as in Example 5 except that the highly heat-resistant transparent film used was changed from film A1 to film G. At this time, the bonded surface is a polyimide surface formed from the polyamic acid solution 2. The evaluation of the obtained laminate is as presented in Table 6.

(Comparative Example 5)

A laminate was obtained in the same manner as in Example 5 except that the highly heat-resistant transparent film used was changed from film A1 to film K. At this time, the bonded surface is a polyimide surface that is in contact with the support when the polyamic acid solution is applied. The evaluation of the obtained laminate is as presented in Table 6.

(Comparative Example 6)

A laminate was obtained in the same manner as in Example 5 except that the highly heat-resistant transparent film used was changed from film A1 to film L. At this time, the bonded surface is a polyimide surface formed from the polyamic acid solution 3. The evaluation of the obtained laminate is as presented in Table 6.

<Measurement of 90° initial peel strength>

The laminates obtained in the above-described fabrication of laminate were subjected to heat treatment at 100°C for 10 minutes in an atmospheric ambience. Thereafter, the 90° initial peel strength between the inorganic substrate (glass substrate or silicon wafer) and the polyimide film was measured. The results are presented in Tables 2 to 6.
The measurement conditions for 90° initial peel strength are as follows.
The film is peeled off from the inorganic substrate at an angle of 90°.
The measurement is performed 5 times and the average value thereof is taken as the measured value.

Measuring instrument: Autograph AG-IS manufactured by Shimadzu Corporation
Measured temperature: Room temperature (25°C)
Peeling speed: 100 mm/min
Ambience: Atmosphere
Width of measured sample: 2.5 cm

<Measurement of 90° peel strength after heating at 300°C for 1 hour>

The laminates obtained in the above-described fabrication of laminate were subjected to heat treatment at 100°C for 10 minutes in an atmospheric ambience. The laminates were further heated at 300°C for 1 hour in a nitrogen ambience. Thereafter, the 90° peel strength between the inorganic substrate and the polyimide film was measured. The results are presented in Tables 2 to 6. The measurement conditions for 90° peel strength after heating at 300°C for 1

hour were similar to those for the 90° initial peel strength.

<Haze of polyimide film>

The haze of the polyimide film was measured using HAZEMETER (NDH5000 manufactured by NIPPON DENSHOKU INDUSTRIES CO., LTD.). A D65 lamp was used as the light source. The same measurement was performed 3 times and the arithmetic mean value thereof was adopted.
The results are presented in Tables 2 to 6.

<Total light transmittance of polyimide film>

The total light transmittance (TT) of the polyimide film was measured using HAZEMETER (NDH5000 manufactured by NIPPON DENSHOKU INDUSTRIES CO., LTD.). A D65 lamp was used as the light source. The same measurement was performed 3 times and the arithmetic mean value thereof was adopted.
The results are presented in Tables 2 to 6.

<Color of polyimide film>

The yellow index was measured. Using a color meter (ZE6000 manufactured by NIPPON DENSHOKU INDUSTRIES CO., LTD.) and a C2 light source, the tristimulus values, XYZ values of the polyimide film were measured in conformity with ASTM D1925, and the yellow index (YI) was calculated by the following equation. The same measurement was performed 3 times and the arithmetic mean value thereof was adopted.

$$YI = 100 \times (1.28X - 1.06Z)/Y$$

The results are presented in Tables 2 to 6.

<Warpage of laminate of highly heat-resistant transparent film and inorganic substrate>

The warpage (μm) of the laminate of a highly heat-resistant transparent film and an inorganic substrate means the degree of deformation in the thickness direction with respect to the plane direction of the laminate before and after the predetermined heat treatment below. Specifically, as illustrated in Fig. 4, a 100 mm × 100 mm test piece was placed on a surface table at room temperature so as to be concave, the average value of the distances (h1rt, h2rt, h3rt, h4rt: unit mm) from the planes at the four corners was taken as the original warped amount (mm). The test piece was subjected to heat treatment at 300°C for 1 hour and then placed on a plane so as to be concave, the average value of the distances (h1, h2, h3, h4: unit mm) from the planes at the four corners was taken as the warped amount (mm), and the difference between this warped amount and the original warped amount was taken as the warped amount at 300°C. The average value for 10 laminates was taken as the measured value.
However, even when there are not enough laminates to sample 10 laminates, the measurement was performed on 3 or more laminates. Specifically, the warped amounts are calculated by the following equations.

$$\text{Original warped amount } (\mu m) = (h1rt + h2rt + h3rt + h4rt)/4$$

$$\text{Warped amount } (\mu m) = (h1 + h2 + h3 + h4)/4$$

Warped amount at 300°C (μm) = warped amount - original warped amount
The results are presented in Tables 2 to 6.

[Table 3]

| | Example 1 | Example 2 | Example 3 | Example 4 | Example 5 | Example 6 |
|---|---|---|---|---|---|---|
| Film | Film A1 | Film B | Film C | Film D1 | Film D2 | Film D2 |

(continued)

| | Example 1 | Example 2 | Example 3 | Example 4 | Example 5 | Example 6 |
|---|---|---|---|---|---|---|
| Kind of inorganic substrate | Glass 1 | Glass 1 | Glass 1 | Glass 1 | Glass 1 | Glass 1 |
| SCA application method | Gas phase method | Gas phase method | Gas phase method | Gas phase method | Gas phase method | Spin coating |
| SCA-coated substrate | Glass 1 | Glass 1 | Glass 1 | Glass 1 | Glass 1 | Glass 1 |
| SCA application time | 5 | 7 | 5 | 5 | 10 | 0.5 |
| Initial peel strength (N/cm) | 0.09 | 0.08 | 0.15 | 0.09 | 0.19 | 0.08 |
| Peel strength after heating at 300°C (N/cm) | 0.12 | 0.18 | 0.12 | 0.09 | 0.13 | 0.12 |
| Haze (initial) | 0.3 | 0.5 | 0.9 | 0.3 | 0.7 | 0.5 |
| Haze (after heating at 300°C) | 0.5 | 0.6 | 0.8 | 0.8 | 0.9 | 0.9 |
| Total light transmittance (initial) | 87.6 | 87.6 | 87.3 | 85.0 | 86.6 | 85.9 |
| Total light transmittance (after heating at 300°C) | 86.9 | 85.0 | 85.3 | 84.1 | 85.7 | 85.7 |
| Color (initial) | 4.7 | 3.2 | 3.5 | 6.5 | 6.3 | 5.9 |
| Color (after heating at 300°C) | 5.6 | 5.9 | 6.7 | 7.5 | 7.2 | 6.7 |
| Warpage (after heating at 300°C) (%) | 2.7 | 3.6 | 2.8 | 3 | 4.6 | 2.5 |

[Table 4]

| | Example 7 | Example 8 | Example 9 | Example 10 | Example 11 | Example 12 | Example 13 |
|---|---|---|---|---|---|---|---|
| Film | Film A1 | Film A1 | Film A3 | Film A3 | Film A2 | Film D2 | Film D2 |
| Kind of inorganic substrate | Glass 1 | Glass 1 | Glass 1 | Glass 1 | Glass 1 | Glass 2 | Si wafer |
| SCA application method | Spin coating | Gas phase method | Gas phase method | Gas phase method | Gas phase method | Gas phase method | Gas phase method |
| SCA-coated substrate | Glass 1 | Film A | Film A3 | Glass 1 | Glass 1 | Glass 2 | Si |
| SCA application time | 0.5 | 10 | 5 | 10 | 10 | 5 | 10 |
| Initial peel strength (N/cm) | 0.10 | 0.10 | 0.09 | 0.1 | 0.09 | 0.14 | 0.16 |
| Peel strength after heating at 300°C (N/cm) | 0.14 | 0.12 | 0.1 | 0.14 | 0.27 | 0.15 | 0.08 |
| Haze (initial) | 0.6 | 0.7 | 0.5 | 1.0 | 0.7 | 0.8 | 0.5 |
| Haze (after heating at 300°C) | 0.5 | 0.8 | 1.2 | 0.9 | 0.9 | 0.7 | 0.6 |

(continued)

| | Example 7 | Example 8 | Example 9 | Example 10 | Example 11 | Example 12 | Example 13 |
|---|---|---|---|---|---|---|---|
| Total light transmittance (initial) | 87.1 | 87.5 | 87.5 | 86.3 | 87.4 | 86.4 | 86.5 |
| Total light transmittance (after heating at 300°C) | 84.8 | 85.9 | 86.4 | 84.2 | 87.3 | 86.3 | 85.9 |
| Color (initial) | 3.5 | 3.6 | 3.5 | 7.1 | 5.5 | 5.2 | 6.0 |
| Color (after heating at 300°C) | 5.0 | 5.1 | 4.2 | 7.5 | 8.4 | 7.4 | 7.6 |
| Warpage (after heating at 300°C) | 0.5 | 2.3 | 1.5 | 2.8 | 7.2 | 3.4 | 3.4 |

[Table 5]

| | Example 14 | Example 15 | Example 16 | Example 17 | Example 18 | Example 19 | Example 20 |
|---|---|---|---|---|---|---|---|
| Film | Film M | Film N | Film O | Film P | Film Q | Film R | Film U |
| Kind of inorganic substrate | Glass 1 | Glass 1 | Glass 1 | Glass 1 | Glass 1 | Glass 1 | Glass 1 |
| SCA application method | Gas phase method | Gas phase method | Gas phase method | Gas phase method | Gas phase method | Gas phase method | Gas phase method |
| SCA-coated substrate | Glass 1 | Glass 1 | Glass 1 | Glass 1 | Glass 1 | Glass 1 | Glass 1 |
| SCA application time | 5 | 5 | 5 | 5 | 5 | 5 | 5 |
| Initial peel strength (N/cm) | 0.09 | 0.07 | 0.1 | 0.09 | 0.09 | 0.09 | 0.1 |
| Peel strength after heating at 300°C (N/cm) | 0.11 | 0.15 | 0.17 | 0.12 | 0.12 | 0.11 | 0.21 |
| Haze (initial) | 0.4 | 0.5 | 0.6 | 0.6 | 0.6 | 0.7 | 0.4 |
| Haze (after heating at 300°C) | 0.5 | 0.5 | 0.5 | 0.7 | 0.7 | 0.8 | 0.5 |
| Total light transmittance (initial) | 86.2 | 87.1 | 88.1 | 88.1 | 87.2 | 86.1 | 89.1 |
| Total light transmittance (after heating at 300°C) | 84.5 | 84.3 | 84.4 | 86.9 | 85.1 | 84.4 | 86.9 |
| Color (initial) | 3.3 | 3.7 | 3.4 | 3.9 | 4.1 | 3.5 | 3.3 |
| Color (after heating at 300°C) | 4.9 | 5.2 | 5.1 | 4.9 | 5.3 | 5.1 | 4.9 |
| Warpage (after heating at 300°C) | 2.7 | 2.9 | 0.7 | 0.5 | 0.4 | 0.4 | 2.1 |

[Table 6]

| | Comparative Example 1 | Comparative Example 2 | Comparative Example 3 | Comparative Example 4 | Comparative Example 5 | Comparative Example 6 |
|---|---|---|---|---|---|---|
| Film | Film E | Film E | Film F | Film G | Film K | Film L |
| Kind of inorganic substrate | Glass 1 | Glass 1 | Glass 1 | Glass 1 | Glass 1 | Glass 1 |
| Film treatment method | Gas phase method | Spin coating | Gas phase method | Gas phase method | Gas phase method | Gas phase method |
| SCA-coated substrate | Glass 1 | Glass 1 | Glass 1 | Glass 1 | Glass 1 | Glass 1 |
| SCA application time | 5 | 0.5 | 5 | 10 | 10 | 10 |
| Initial peel strength (N/cm) | 0.82 | 0.90 | 1.60 | 0.77 | 1.9 | 1.2 |
| Peel strength after heating at 300°C (N/cm) | 2.9 | 2.5 | 4.7 | 3.4 | 4.1 | 6.1 |
| Haze (initial) | 0.3 | 0.3 | 0.2 | 0.6 | 0.4 | 0.6 |
| Haze (after heating at 300°C) | 0.4 | 0.4 | 0.4 | 0.6 | 0.5 | 0.6 |
| Total light transmittance (initial) | 87 | 87 | 87 | 88 | 86 | 88 |
| Total light transmittance (after heating at 300°C) | 86 | 85 | 84 | 86 | 85 | 86 |
| Color (initial) | 2.0 | 2.0 | 3.6 | 2.9 | 3.3 | 4.2 |
| Color (after heating at 300°C) | 6.3 | 5.8 | 5.4 | 6.2 | 5.5 | 5.0 |
| Warpage (after heating at 300°C) | 6.7 | 9.6 | 9.3 | 10.4 | 11.4 | 10.1 |

DESCRIPTION OF REFERENCE SIGNS

1 Flow meter
2 Gas inlet
3 Chemical tank (silane coupling agent tank)
4 Hot water tank (water bath)
5 Heater
6 Processing chamber (chamber)

7 Base material
8 Exhaust port
11 First highly heat-resistant transparent film layer
12 Second highly heat-resistant transparent film layer
13 Silane coupling agent layer
14 Inorganic substrate
15 Electronic device
16 Film with electronic device
17 Laminate
18 Surface table

**Claims**

**1.** A laminate comprising a highly heat-resistant transparent film and an inorganic substrate, wherein

an adhesive is not substantially used,
a peel strength between the highly heat-resistant transparent film and the inorganic substrate is 0.3 N/cm or less, and
a CTE of the highly heat-resistant transparent film is 50 ppm/K or less.

**2.** The laminate according to claim 1, wherein the highly heat-resistant transparent film has a laminated configuration of two or more layers, and a thickness of intermingling at an interface between a first highly heat-resistant transparent film layer that is in contact with the inorganic substrate and a second highly heat-resistant transparent film layer that is not in contact with the inorganic substrate but is adjacent to the first highly heat-resistant transparent film layer is 800 nm or less.

**3.** The laminate according to claim 1 or 2, wherein the highly heat-resistant transparent film has a laminated configuration of two or more layers, and a CTE of a first highly heat-resistant transparent film layer that is in contact with the inorganic substrate singly is 20 ppm/K or less.

**4.** The laminate according to any one of claims 1 to 3, wherein the highly heat-resistant transparent film has a laminated configuration of two or more layers, and a first highly heat-resistant transparent film layer that is in contact with the inorganic substrate is transparent polyimide.

**5.** The laminate according to any one of claims 1 to 4, wherein the highly heat-resistant transparent film has a laminated configuration of two or more layers, and at least one layer of a second highly heat-resistant transparent film layer that is not in contact with the inorganic substrate is transparent polyimide.

**6.** The laminate according to any one of claims 1 to 5, wherein the highly heat-resistant transparent film has a laminated configuration of two or more layers, and a first highly heat-resistant transparent film layer that is in contact with the inorganic substrate includes a structure represented by Formula 1 and/or a structure represented by Formula 2:

[Formula 1]

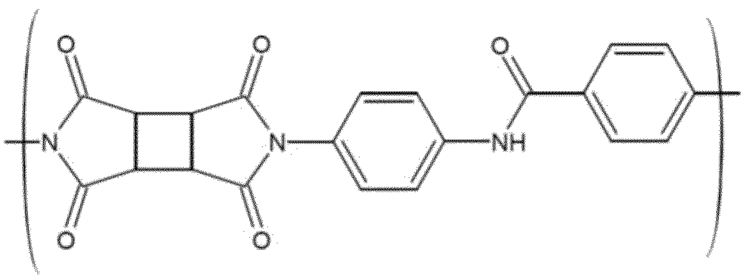

[Formula 2]

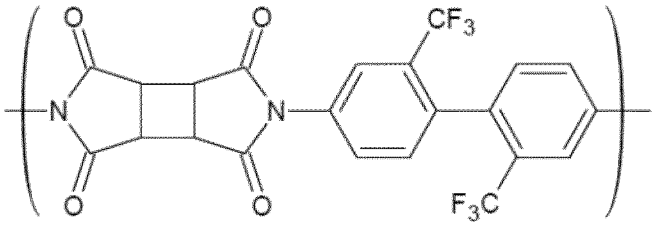

7. The laminate according to any one of claims 1 to 6, wherein a long side of the inorganic substrate is 300 mm or more.

8. A method for manufacturing a film with an electronic device, the method comprising forming an electronic device on a highly heat-resistant transparent film of the laminate according to any one of claims 1 to 7 and then peeling off the electronic device-formed highly heat-resistant transparent film from an inorganic substrate.

Fig.1

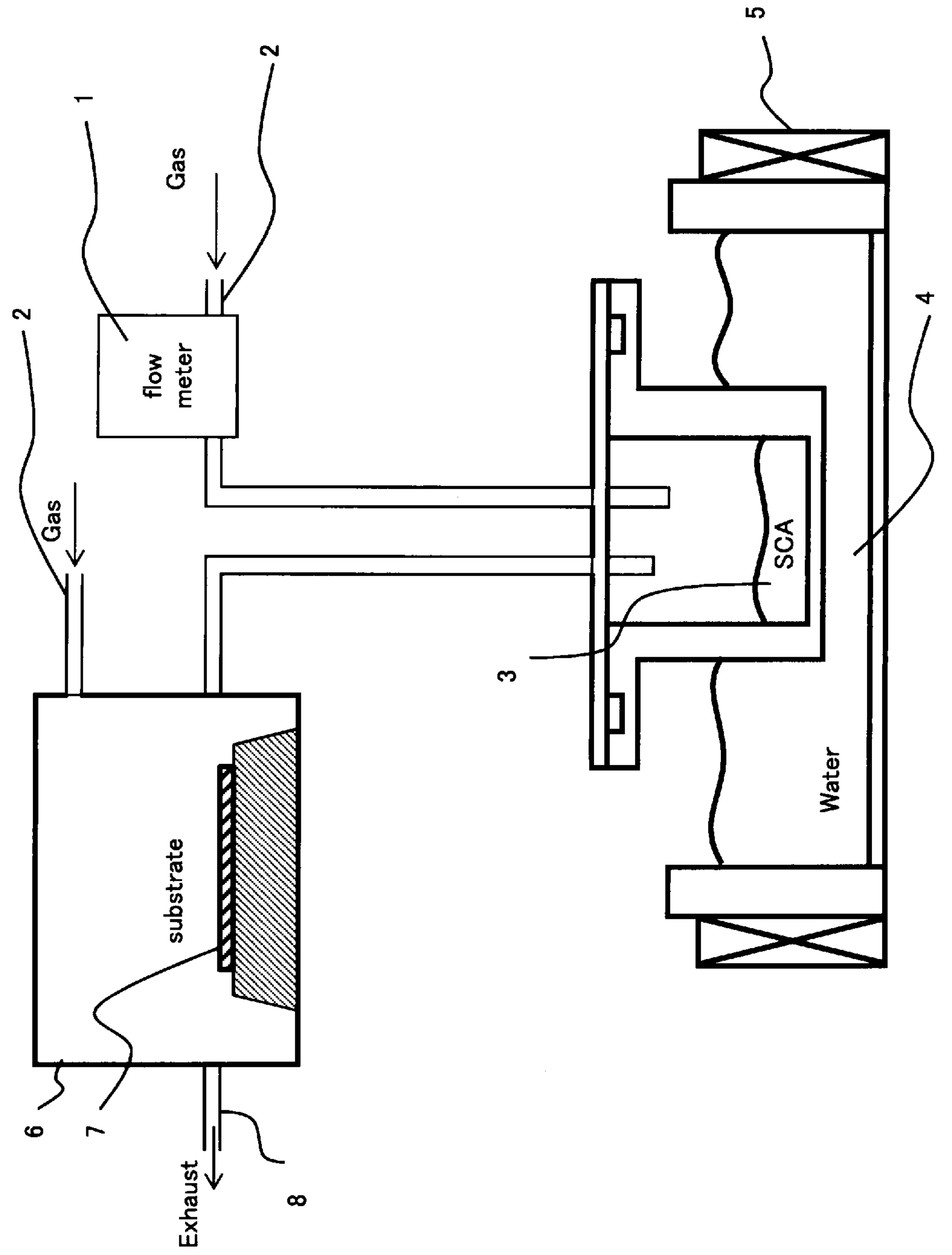

Fig.2

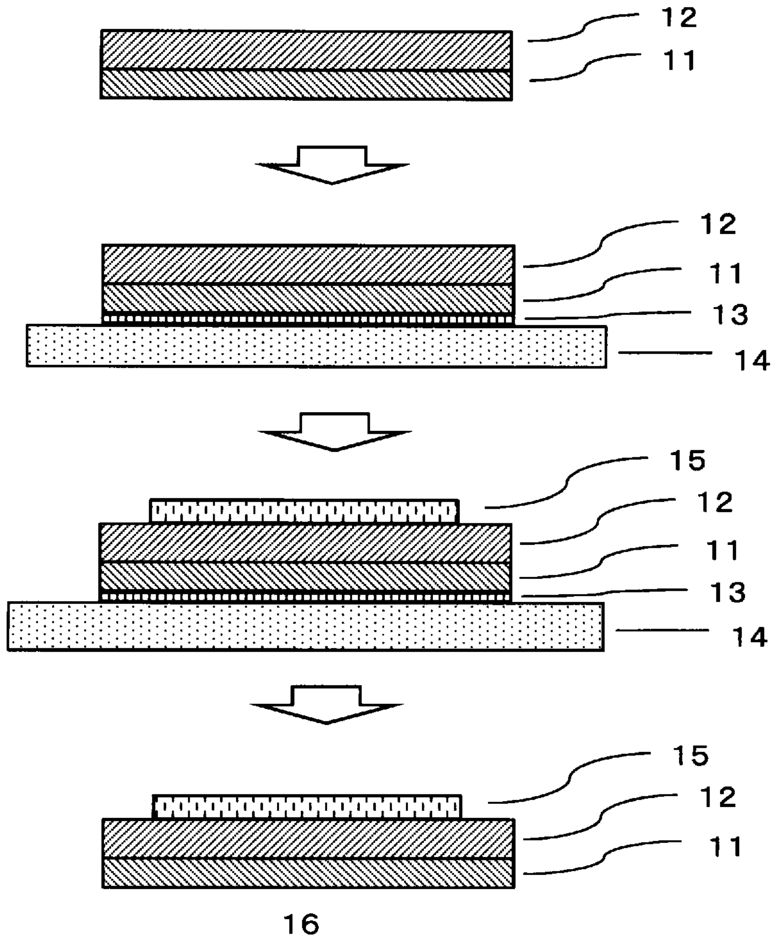

Fig.3

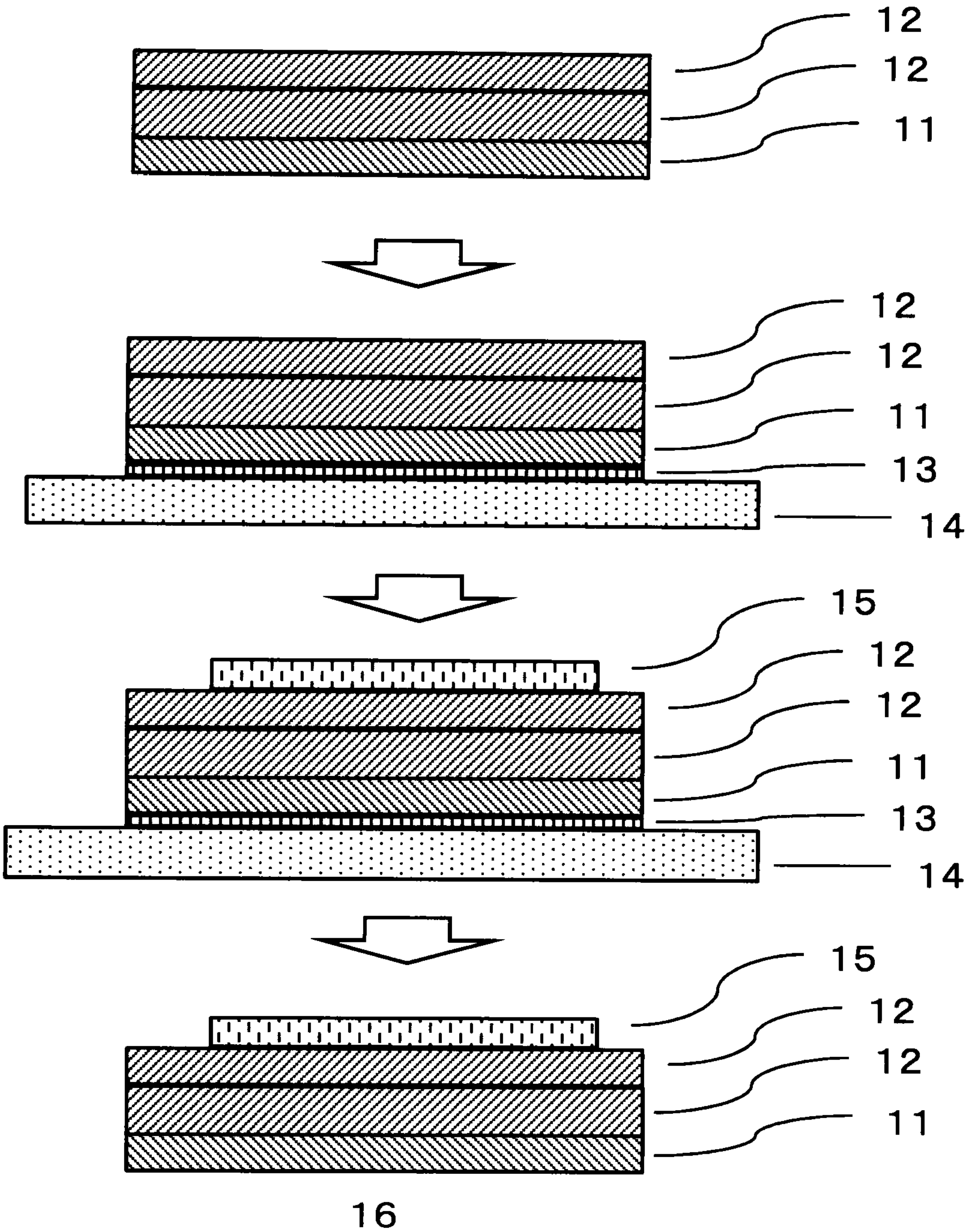

Fig.4

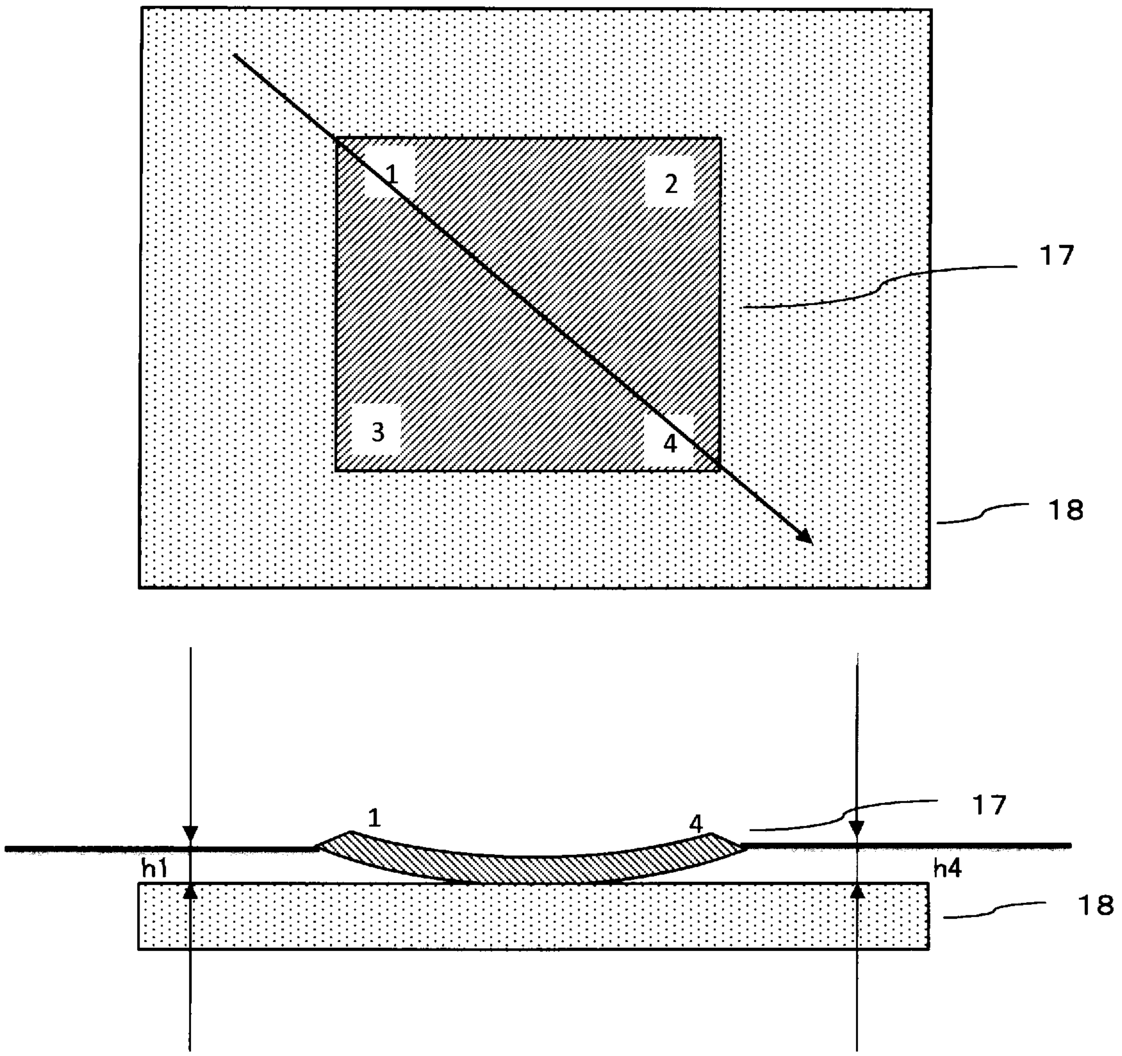

**INTERNATIONAL SEARCH REPORT**

International application No. PCT/JP2021/019786

A. CLASSIFICATION OF SUBJECT MATTER
B32B 17/10(2006.01)i; B32B 27/34(2006.01)i; C08L 79/08(2006.01)i; G09F 9/00(2006.01)i; H05B 33/02(2006.01)i; H05B 33/10(2006.01)i; H01L 51/50(2006.01)i
FI: B32B27/34; B32B17/10; C08L79/08 B; C08L79/08 C; H05B33/10; H05B33/14 A; H05B33/02; G09F9/00 342
According to International Patent Classification (IPC) or to both national classification and IPC

B. FIELDS SEARCHED
Minimum documentation searched (classification system followed by classification symbols)
B32B17/10; B32B27/34; C08L79/08; G09F9/00; H05B33/02; H05B33/10; H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2013-226784 A (TOYOBO CO., LTD.) 07 November 2013 (2013-11-07) claims 1, 9, paragraphs [0016], [0045], [0060], [0078], tables 2, 5 | 1-8 |
| X | WO 2015/182419 A1 (KANEKA CORP.) 03 December 2015 (2015-12-03) claims 1, 10-14, paragraph [0064], tables 1, 2 | 1-5, 7-8 |
| X | KR 10-2097431 B1 (SKCKOLONPI INC.) 07 April 2020 (2020-04-07) claims 1, 11, paragraphs [0051]-[0073], table 2 | 1-5, 7-8 |
| A | JP 2010-283262 A (TOYOBO BOSEKI KABUSHIKI KAISHA) 16 December 2010 (2010-12-16) entire text | 1-8 |
| A | WO 2012/050072 A1 (TOYOBO CO., LTD.) 19 April 2012 (2012-04-19) entire text | 1-8 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 08 July 2021 (08.07.2021) | 20 July 2021 (20.07.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

International application No. PCT/JP2021/019786

C (Continuation). DOCUMENTS CONSIDERED TO BE RELEVANT

| Category* | Citation of document, with indication, where appropriate, of the relevant passages | Relevant to claim No. |
|---|---|---|
| A | WO 2012/141293 A1 (TOYOBO CO., LTD.) 18 October 2012 (2012-10-18) entire text | 1-8 |
| A | WO 2019/131294 A1 (KANEKA CORP.) 04 July 2019 (2019-07-04) entire text | 1-8 |
| A | WO 2015/012339 A1 (UNITIKA LTD.) 29 January 2015 (2015-01-29) entire text | 1-8 |
| A | KR 10-2013534 B1 (SKCKOLONPI INC.) 22 August 2019 (2019-08-22) entire text | 1-8 |

Form PCT/ISA/210 (continuation of second sheet) (January 2015)

**INTERNATIONAL SEARCH REPORT**
Information on patent family members

International application No.
PCT/JP2021/019786

| Patent Documents referred in the Report | Publication Date | Patent Family | Publication Date |
|---|---|---|---|
| JP 2013-226784 A | 07 Nov. 2013 | (Family: none) | |
| WO 2015/182419 A1 | 03 Dec. 2015 | US 2017/0190910 A1 claims 1, 10-14, paragraph [0076], tables 1, 2<br>KR 10-2017-0010380 A<br>CN 106471065 A<br>TW 201602185 A | |
| KR 10-2097431 B1 | 07 Apr. 2020 | (Family: none) | |
| JP 2010-283262 A | 16 Dec. 2010 | (Family: none) | |
| WO 2012/050072 A1 | 19 Apr. 2012 | TW 201223356 A | |
| WO 2012/141293 A1 | 18 Oct. 2012 | US 2014/0042662 A1<br>CN 103619591 A<br>KR 10-2014-0027265 A<br>TW 201307061 A | |
| WO 2019/131294 A1 | 04 Jul. 2019 | CN 111527150 A<br>TW 201930402 A | |
| WO 2015/012339 A1 | 29 Jan. 2015 | CN 105408115 A<br>TW 201509682 A | |
| KR 10-2013534 B1 | 22 Aug. 2019 | WO 2020/138743 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2018132768 A
- JP 5304490 B